# EUROPÄISCHE PATENTANMELDUNG

(11) **EP 3 553 814 A1**
(43) Veröffentlichungstag der Anmeldung: **16.10.2019**
(21) Anmeldenummer: 18166681.9
(22) Anmeldetag: 10.04.2018
(51) Int. Cl.: H01L 21/67, H01L 21/677, B23Q 1/38, G01B 11/27

(54) **POSITIONIERVORRICHTUNG, BE- UND/ODER ENTLADESYSTEM UND VERFAHREN ZUM BETRIEB EINER POSITIONIERVORRICHTUNG**

(71) Anmelder: VAT Holding AG, 9469 Haag (CH)
(72) Erfinder: Ehrne, Florian, 9469 Frümsen (CH); Netzer, Martin, 6700 Bludenz (AT); Hofer, Andreas, 9443 Widnau (CH); Apolloni, Marco, 9437 Marbach (CH)
(74) Vertreter: Daub, Thomas

(57) **Zusammenfassung**

Die Erfindung geht aus von einer Positioniervorrichtung, insbesondere einer Wafer-Transportbehältnis-Positioniervorrichtung, zu einer Positionierung eines Wafer-Transportbehältnisses (10a-d) in einer Be- und/oder Entladeposition einer zumindest zum Be- und/oder Entladen von Wafern (12a-d) aus dem Wafer-Transportbehältnis (10a-d) vorgesehenen Be- und/oder Entladestation (14a-d).

Es wird vorgeschlagen, dass die Positioniervorrichtung, insbesondere die Wafer-Transportbehältnis-Positioniervorrichtung, einen Positioniermechanismus (16a-d) aufweist, welcher zu einer berührungslosen Positionierung des Wafer-Transportbehältnisses (10a-d) bei einem Koppelvorgang des Wafer-Transportbehältnisses (10a-d) mit der Be- und/oder Entladestation (14a-d) vorgesehen ist.

## Beschreibung

### Stand der Technik

Die Erfindung betrifft eine Positioniervorrichtung, insbesondere eine Wafer-Transportbehältnis-Positioniervorrichtung, nach dem Oberbegriff des Anspruchs 1, ein Be- und/oder Entladesystem nach Anspruch 19 und ein Verfahren zum Betrieb einer Positioniervorrichtung nach dem Oberbegriff des Anspruchs 20.

Es ist bereits eine Positioniervorrichtung zu einer Positionierung eines Wafer-Transportbehältnisses in einer Be- und/oder Entladeposition einer zumindest zum Be- und/oder Entladen von Wafern aus dem Wafer-Transportbehältnis vorgesehenen Be- und/oder Entladestation vorgeschlagen worden.

Die Aufgabe der Erfindung besteht insbesondere darin, eine gattungsgemäße Vorrichtung mit vorteilhaften Eigenschaften hinsichtlich einer Positionierung eines Wafer-Transportbehältnisses auf einer Be- und/oder Entladestation für Wafer aus dem Wafer-Transportbehältnis bereitzustellen. Die Aufgabe wird erfindungsgemäß durch die Merkmale der Patentansprüche 1, 19 und 20 gelöst, während vorteilhafte Ausgestaltungen und Weiterbildungen der Erfindung den Unteransprüchen entnommen werden können.

### Vorteile der Erfindung

Die Erfindung geht aus von einer Positioniervorrichtung, insbesondere einer Wafer-Transportbehältnis-Positioniervorrichtung, zu einer Positionierung eines Wafer-Transportbehältnisses in einer Be- und/oder Entladeposition einer zumindest zum Be- und/oder Entladen von Wafern aus dem Wafer-Transportbehältnis vorgesehenen Be- und/oder Entladestation.

Es wird vorgeschlagen, dass die Positioniervorrichtung, insbesondere die Wafer-Transportbehältnis-Positioniervorrichtung, einen Positioniermechanismus aufweist, welcher zu einer berührungslosen Positionierung des Wafer-Transportbehältnisses bei einem Koppelvorgang des Wafer-Transportbehältnisses mit der Be- und/oder Entladestation vorgesehen ist. Dadurch können vorteilhafte Eigenschaften hinsichtlich einer Positionierung eines Wafer-Transportbehältnisses auf einer Be- und/oder Entladestation für Wafer aus dem Wafer-Transportbehältnis erreicht werden. Insbesondere kann vorteilhaft eine Partikelgeneration bei einem Koppelvorgang mittels des Positioniermechanismus reduziert und/oder vermieden werden, insbesondere indem eine, insbesondere zu einer Partikelgeneration führende, äußere Reibung zwischen Festkörpern, insbesondere zwischen dem Wafer-Transportbehältnis und der Be- und/oder Entladestation, vermieden werden kann. Eine Partikelvermeidung ist insbesondere unter Reinraumbedingungen, unter welchen insbesondere eine Wafer-Herstellung und/oder eine Wafer-Bearbeitung in einer Wafer-Fabrikationsanlage typischerweise abläuft, von Vorteil, da selbst kleinste Partikel Wafer beschädigen können. Zudem können Partikel eine ordnungsgemäße Funktion von Vakuumdichtungen beeinträchtigen und insbesondere zu einer Reduktion einer Dichtigkeit der Vakuumdichtungen führen, beispielsweise indem sie sich zwischen Vakuumdichtungselementen ablagern. Eine entsprechende Reduktion einer Partikelanzahl durch eine Vermeidung einer Partikelgeneration in einer Umgebung der Vakuumdichtungen kann demnach vorteilhaft eine hohe Dichtigkeit der Vakuumdichtungen, insbesondere auch bei einem häufigen Öffnen und/oder Schließen der Vakuumdichtungen, ermöglichen. Zudem kann mittels einer Vermeidung von Oberflächenkontakten durch eine berührungslose Positionierung ein Materialverschleiß reduziert werden, wodurch vorteilhaft eine hohe Lebensdauer, insbesondere mit einer über die Lebensdauer anhaltend hohen Positionierungspräzision, erreicht werden kann. Sich berührende Führungselemente eines berührenden Positioniermechanismus können beispielsweise mit der Zeit abnutzen, wodurch sich ein Spiel bei einer Positionierung vergrößern kann. Ein derartiger Effekt kann mittels der berührungslosen Positionierung vorteilhaft vermieden werden. Zudem kann mittels des berührungslosen Positioniermechanismus vorteilhaft eine besonders gleichmäßige und/oder ruckelfreie Positionierung ermöglicht werden, insbesondere im Gegensatz zu einer berührenden Positionierung, bei welcher beispielsweise durch Haftreibung und/oder durch Unebenheiten in zumindest einer der sich berührenden Oberflächen ruckartige Beschleunigungen auftreten können, welche zu einem Verrutschen von in dem Wafer-Transportbehältnis gelagerten Wafern führen können. Dadurch können vorteilhaft Beschädigungen von Wafern durch Verrutschen vermieden werden.

Eine "Positioniervorrichtung", insbesondere eine "Wafer-Transportbehältnis-Positioniervorrichtung", ist insbesondere dazu vorgesehen, eine, insbesondere zumindest zweidimensionale, vorzugsweise dreidimensionale, Bewegung eines Wafer-Transportbehältnisses, insbesondere bei einem Koppelvorgang, zu beeinflussen und vorzugsweise derart zu lenken und/oder zu steuern, dass das Wafer-Transportbehältnis eine vorgesehene räumliche Ausrichtung bei einem Annähern an eine Be- und/oder Entladeposition und/oder bei einem Absetzen in der Be- und/oder Entladeposition einnimmt. Insbesondere kann die Positioniervorrichtung, insbesondere die Wafer-Transportbehältnis-Positioniervorrichtung, dazu vorgesehen sein, zumindest eine Vorpositionierung des Wafer-Transportbehältnisses bei einer Annäherung des Wafer-Transportbehältnisses an eine Be- und/oder Entladestation so vorzunehmen, dass eine Abweichung einer Ausrichtung des Wafer-Transportbehältnisses von einer idealen Ausrichtung relativ zu der Be- und/oder Entladeposition und/oder von einer idealen Positionierung des Wafer-Transportbehältnisses in der Be- und/oder Entladeposition möglichst klein ist. Darunter, dass eine "Abweichung möglichst klein ist", soll insbesondere verstanden werden, dass das Wafer-Transportbehältnis höchstens um 2°, vorzugsweise höchstens um 1°, vorteilhaft höchstens um 0,6°, bevorzugt höchstens um 0,3° und besonders bevorzugt höchstens um 0,1° relativ zu einer idealen Be- und/oder Entladeposition verdreht ist und/oder dass das Wafer-Transportbehältnis höchstens um 3 mm, vorzugsweise um höchstens 2 mm, vorteilhaft um höchstens 1 mm, besonders vorteilhaft um höchstens 0,6 mm, bevorzugt um höchstens 0,3 mm und besonders bevorzugt um höchstens 0,1 mm relativ zu der idealen Be- und/oder Entladeposition in eine beliebige Richtung versetzt ist. Unter einer "Positionierung" soll insbesondere eine rotatorische und/oder eine translatorische Positionierung relativ zu der idealen Be- und/oder Entladeposition verstanden werden. Bei einer idealen Ausrichtung und/oder einer idealen Positionierung überlappen zu einer Kopplung vorgesehene Kontaktbereiche des Wafer-Transportbehältnisses und der Be- und/oder Entladestation vollständig. Vorzugsweise ist die Positionierung als eine Vorpositionierung ausgebildet, welche insbesondere nach einer Grobpositionierung stattfindet, wobei die Grobpositionierung, beispielsweise mittels einer Anlieferung durch ein Wafer-Transportbehältnis-Transportsystem einer Wafer-Fabrikationsanlage, bewerkstelligt wird. Zudem findet die Positionierung, insbesondere die Vorpositionierung, vor einer Endpositionierung statt. Die Endpositionierung kann beispielsweise mittels Positionier- und/oder Führungspins bewerkstelligt werden, wobei die Positionier- und/oder Führungspins vorzugsweise dazu vorgesehen sind, in der Be- und/oder Entladeposition einen Formschluss zwischen dem Wafer-Transportbehältnis und der Be- und/oder Entladestation herzustellen. Insbesondere befindet sich das Wafer-Transportbehältnis im Anschluss an die Endpositionierung in der idealen Be- und/oder Entladeposition. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Unter einem "Wafer-Transportbehältnis" soll insbesondere ein Transportbehältnis mit einem verschließbaren Innenraum verstanden werden, wobei der Innenraum dazu vorgesehen ist, Wafer aufzunehmen. Insbesondere ist das Wafer-Transportbehältnis zumindest zu einem Transport von Wafern mit zumindest einem Durchmesser von 200 mm, vorzugsweise zumindest von 300 mm und bevorzugt zumindest von 450 mm vorgesehen. Insbesondere ist das Wafer-Transportbehältnis zumindest zu einem Transport von zumindest einem Wafer, vorzugsweise zumindest drei Wafern, vorteilhaft zumindest fünf Wafern, besonders vorteilhaft zumindest zehn Wafern, bevorzugt zumindest 25 Wafern und besonders bevorzugt höchstens hundert Wafern vorgesehen. Alternativ oder zusätzlich ist das Wafer-Transportbehältnis dazu vorgesehen, zumindest ein von einem Wafer verschieden ausgebildetes Objekt aufzunehmen, beispielsweise eine Belichtungsmaske. Insbesondere ist das Wafer-Transportbehältnis tragbar ausgebildet. Insbesondere ist das Wafer-Transportbehältnis vakuumdicht verschließbar ausgebildet. Vorzugsweise ist das Wafer-Transportbehältnis als ein Vakuum-Wafer-Transportbehältnis ausgebildet, welches insbesondere dazu vorgesehen ist, in seinem Inneren eine Vakuumatmosphäre bereitzustellen und/oder zu halten. Insbesondere ist das Wafer-Transportbehältnis dazu vorgesehen, Wafer in der Vakuumatmosphäre zu lagern. Unter einer "Vakuumatmosphäre" soll insbesondere eine Atmosphäre verstanden werden, deren Druck unterhalb von 300 hPa, vorzugsweise unterhalb von 1 hPa, bevorzugt unterhalb von 10⁻³ hPa und besonders bevorzugt unterhalb von 10⁻⁶ hPa liegt. Insbesondere weist das Wafer-Transportbehältnis unter der Vakuumatmosphäre eine hohe Dichtigkeit auf, wobei insbesondere die Leckrate des Wafer-Transportbehältnisses kleiner als 10⁻⁴ mbar*I/s, vorzugsweise kleiner als 10⁻⁵ mbar*l/s, vorteilhaft kleiner als 10⁻⁶ mbar*l/s, besonders vorteilhaft kleiner als 10⁻⁷ mbar*l/s, bevorzugt kleiner als 10⁻⁸ mbar*I/s und besonders bevorzugt kleiner als 10⁻⁹ mbar*I/s ist. Alternativ kann das Wafer-Transportbehältnis dazu vorgesehen sein, Wafer in einer Standardatmosphäre und/oder in einer speziell zusammengestellten Atmosphäre, beispielsweise einer Stickstoffatmosphäre, zu lagern und/oder zu halten. Das Wafer-Transportbehältnis weist insbesondere eine Außenhülle auf, welche zumindest teilweise aus einem, insbesondere diamagnetischen, paramagnetischen oder ferromagnetischen, Material ausgebildet ist, das vorzugsweise durch ein äußeres magnetisches Feld abgestoßen und/oder angezogen wird.

Unter einer "Be- und/oder Entladeposition" soll insbesondere eine Position des Wafer-Transportbehältnisses relativ zu der Be- und/oder Entladestation verstanden werden, welche dazu vorgesehen ist, zumindest einen Wafer aus dem Wafer-Transportbehältnis in die Be- und/oder Entladestation umzuladen und/oder zumindest einen Wafer aus der Be- und/oder Entladestation in das Wafer-Transportbehältnis umzuladen. In der Be- und/oder Entladeposition ist das Wafer-Transportbehältnis, insbesondere ein Inneres des Wafer-Transportbehältnisses, vorzugsweise vakuumdicht, mit der Be- und/oder Entladestation, insbesondere mit einem Inneren der Be- und/oder Entladestation, verbindbar. Insbesondere ist in der Be- und/oder Entladeposition ein Wafer-Transportbehältnis-Öffnungselement von einem Grundkörper des Wafer-Transportbehältnisses lösbar und insbesondere zumindest teilweise in ein Inneres der Be- und/oder Entladestation absenkbar. Insbesondere ist das Wafer-Transportbehältnis in der Be- und/oder Entladeposition fest auf einer Oberfläche der Be- und/oder Entladestation fixierbar, beispielsweise mittels eines Vakuumspannens durch eine Vakuumspannvorrichtung. Insbesondere sind das Wafer-Transportbehältnis und die Be- und/oder Entladestation dazu vorgesehen, insbesondere in einem gekoppelten Zustand, in welchem das Wafer-Transportbehältnis auf der Oberfläche der Be- und/oder Entladestation in der Be- und/oder Entladeposition fixiert ist, ein gemeinsames Minienvironment auszubilden. Unter einem "Minienvironment" soll insbesondere eine Einhausung mit einer von einer Umgebungsatmosphäre isolierten Atmosphäre, beispielsweise einem Vakuum, verstanden werden. Unter einem "Koppelvorgang" soll hierbei insbesondere ein Vorgang eines Annäherns und/oder Entfernens des Wafer-Transportbehältnisses an die Be- und/oder Entladestation zu einem anschließenden Fixieren des Wafer-Transportbehältnisses auf der Be- und/oder Entladestation in der Be- und/oder Entladeposition verstanden werden. Unter einem "Wafer" soll insbesondere ein Substrat für elektronische Bauelemente verstanden werden. Die Be- und/oder Entladestation ist zudem insbesondere dazu vorgesehen, Wafer aus dem Wafer-Transportbehältnis an ein Wafer-Prozessmodul, welches insbesondere dazu vorgesehen ist, zumindest einen Bearbeitungs- und/oder Fertigungsschritt an einem Wafer vorzunehmen, weiterzuleiten und/oder bearbeitete Wafer von einem Wafer-Prozessmodul an ein Wafer-Transportbehältnis zu einem Weitertransport, beispielweise an ein weiteres Wafer-Prozessmodul, zu leiten.

Ein "Positioniermechanismus" ist insbesondere dazu vorgesehen, eine Kraft und/oder eine Beschleunigung, welche zu einer Lage- und/oder Positionseinstellung des Wafer-Transportbehältnisses dient, zu erzeugen, zu steuern und/oder zu regeln. Darunter, dass der Positioniermechanismus das Wafer-Transportbehältnis "berührungslos positioniert", soll insbesondere verstanden werden, dass eine Kraftübertragung einer zwischen dem Wafer-Transportbehältnis und der Be- und/oder Entladestation wirkenden positionierenden Kraft des Positioniermechanismus zumindest abschnittsweise berührungslos erfolgt, wobei insbesondere das Wafer-Transportbehältnis und die Be- und/oder Entladestation frei sind von jeglichen gegenseitigen Berührungspunkten. Insbesondere ist die berührungslose Positionierung unabhängig von Seilen und/oder Kabeln, bzw. von durch Seile und/oder Kabel erzeugten Kräften und/oder Beschleunigungen, unabhängig von Positionierungen des Wafer-Transportbehältnis-Transportsystems, welches insbesondere zu einer Logistik von Wafer-Transportbehältnissen innerhalb der Wafer-Fabrikationsanlage vorgesehen ist, und/oder unabhängig von Führungselementen und/oder Formschlusselementen des Wafer-Transportbehältnisses und/oder der Be- und/oder Entladestation, wie beispielsweise Führungspins. Die berührungslose Positionierung kann beispielsweise mittels Magnetkräften, elektrostatischen Kräften und/oder Impulskräften eines strömenden Fluids, insbesondere eines Gases, erfolgen.

Insbesondere erfolgt eine Positionierung durch den Positioniermechanismus in einer Ebene, welche zumindest im Wesentlichen senkrecht zu einer Kopplungsrichtung liegt. Die "Kopplungsrichtung" ist insbesondere als eine Hauptbewegungsrichtung, entlang welcher sich das Wafer-Transportbehältnis bei dem Koppelvorgang bewegt, ausgebildet. Insbesondere verläuft die Kopplungsrichtung zumindest im Wesentlichen senkrecht zu einer Haupterstreckungsebene des Wafer-Transportbehältnis-Öffnungselements. Vorzugsweise ist die Kopplungsrichtung zumindest im Wesentlichen parallel zu einer Gravitationsrichtung ausgebildet. Unter einer "Haupterstreckungsebene" einer Baueinheit soll insbesondere eine Ebene verstanden werden, welche parallel zu einer größten Seitenfläche eines kleinsten gedachten Quaders ist, welcher die Baueinheit gerade noch vollständig umschließt, und insbesondere durch den Mittelpunkt des Quaders verläuft. Unter "im Wesentlichen parallel" soll hier insbesondere eine Ausrichtung einer Richtung relativ zu einer Bezugsrichtung, insbesondere in einer Ebene, verstanden werden, wobei die Richtung gegenüber der Bezugsrichtung eine Abweichung insbesondere kleiner als 8°, vorteilhaft kleiner als 5° und besonders vorteilhaft kleiner als 2° aufweist. Der Ausdruck "im Wesentlichen senkrecht" soll hier insbesondere eine Ausrichtung einer Richtung relativ zu einer Bezugsrichtung definieren, wobei die Richtung und die Bezugsrichtung, insbesondere in einer Ebene betrachtet, einen Winkel von 90° einschließen und der Winkel eine maximale Abweichung von insbesondere kleiner als 8°, vorteilhaft kleiner als 5° und besonders vorteilhaft kleiner als 2° aufweist. Alternativ oder zusätzlich kann die Positionierung mittels des Positioniermechanismus in eine zu der Kopplungsrichtung parallel verlaufende Richtung erfolgen.

Ferner wird vorgeschlagen, dass der Positioniermechanismus zu einer Nahbereichspositionierung des Wafer-Transportbehältnisses in der Be- und/oder Entladeposition vorgesehen ist. Dadurch kann vorteilhaft eine genaue Positionierung, insbesondere eine Vorpositionierung, des Wafer-Transportbehältnisses in der Be- und/oder Entladeposition ermöglicht werden. Zudem kann durch eine Positionierung des Wafer-Transportbehältnisses in einem Nahbereich der Be- und/oder Entladestation vorteilhaft verhindert werden, dass sich eine bereits eingestellte Positionierung, insbesondere eine Vorpositionierung, bei einem anschließenden weiteren Annähern an die Be- und/oder Entladeposition wieder verstellt. Dadurch kann vorteilhaft eine hohe Effektivität der Positionierung erreicht werden. Insbesondere findet eine rasche Grobpositionierung vor der Positionierung außerhalb des Nahbereichs statt. Unter einer "Nahbereichspositionierung" soll insbesondere eine Positionierung des Wafer-Transportbehältnisses in einem Nahbereich der Be- und/oder Entladeposition der Be- und/oder Entladestation verstanden werden. Insbesondere ist der Positioniermechanismus in dem Nahbereich der Be- und/oder Entladestation angeordnet. Insbesondere ist der Positioniermechanismus dazu vorgesehen, eine Kraft zu erzeugen, welche vorzugsweise in dem Nahbereich der Be- und/oder Entladestation wirkt und/oder seine größte Wirkung in dem Nahbereich der Be- und/oder Entladestation entfaltet. Unter einem "Nahbereich" eines Objekts soll insbesondere ein Bereich von Raumpunkten verstanden werden, wobei jeder Raumpunkt höchstens 1 m, vorzugsweise höchstens 20 cm, vorteilhaft höchstens 10 cm, besonders vorteilhaft höchstens 5 cm, bevorzugt höchstens 2 cm und besonders bevorzugt höchstens 0,5 cm von dem Objekt, insbesondere einer Kontaktfläche der Be- und/oder Entladestation, welche vorzugsweise dazu vorgesehen ist, das Wafer-Transportbehältnis in der Be- und/oder Entladeposition berührend zu kontaktieren, entfernt ist. Insbesondere sind das Wafer-Transportbehältnis und die Be- und/oder Entladestation in dem Nahbereich frei von gegenseitigen Berührungen. Insbesondere ist der Nahbereich verschieden von einem Berührungsbereich ausgebildet, in dem sich das Wafer-Transportbehältnis und die Be- und/oder Entladestation gegenseitig berühren.

Zudem wird vorgeschlagen, dass der Positioniermechanismus dazu vorgesehen ist, das Wafer-Transportbehältnis so zu positionieren, dass eine Abweichung von einer idealen Be- und/oder Entladeposition, insbesondere in einer Ebene senkrecht zu der Kopplungsrichtung, höchstens 3 mm, vorzugsweise höchstens 2,5 mm, vorteilhaft höchstens 2 mm, bevorzugt höchstens 1,5 mm und besonders bevorzugt höchstens 1 mm beträgt. Dadurch kann vorteilhaft eine besonders genaue Positionierung des Wafer-Transportbehältnisses in der Be- und/oder Entladeposition erreicht werden. Insbesondere kann dadurch eine sehr genaue Abstimmung einer Vorpositionierung durch den Positioniermechanismus auf einen, beispielsweise Positionierpins umfassenden, Endpositioniermechanismus erreicht werden, wodurch vorteilhaft eine Partikelgeneration, insbesondere durch eine, durch den Endpositioniermechanismus hervorgerufene Reibung gering gehalten werden kann. Dadurch können insbesondere vorteilhafte Eigenschaften hinsichtlich einer Reinraumtauglichkeit und/oder einer Vakuumtauglichkeit des Positioniermechanismus geschaffen werden. Insbesondere ist der Positioniermechanismus dazu vorgesehen, eine Kraft zu erzeugen, deren Kraftwirkung und/oder deren Kraftgradient, insbesondere mittels einer Steuer- und/oder Regeleinheit der Positioniervorrichtung, in einem Millimeterbereich einstellbar ist. Unter einer "Steuer- und/oder Regeleinheit" soll insbesondere eine elektronische Einheit verstanden werden, die vorzugsweise dazu vorgesehen ist, zumindest den Positioniermechanismus, insbesondere zumindest ein Positionierelement des Positioniermechanismus, zu steuern und/oder zu regeln. Vorzugsweise umfasst die Steuereinheit eine Recheneinheit und insbesondere zusätzlich zur Recheneinheit eine Speichereinheit mit einem darin gespeicherten Steuer- und/oder Regelprogramm, das dazu vorgesehen ist, von der Recheneinheit ausgeführt zu werden. Die "ideale Be- und/oder Entladeposition" ist insbesondere als eine Position des Wafer-Transportbehältnisses ausgebildet, in welcher ein Kontaktbereich des Wafer-Transportbehältnisses, insbesondere des Wafer-Transportbehältnis-Öffnungselements, und ein Kontaktbereich eines Öffnungselements der Be- und/oder Entladestation ideal überlappen, insbesondere derart, dass eine maximale Gasdichtigkeit der Verbindung zwischen Wafer-Transportbehältnis und Be- und/oder Entladestation erreicht wird. Insbesondere ist ein gesamter, insbesondere in der Kopplungsrichtung gesehener, durch den Kontaktbereich des Wafer-Transportbehältnis-Öffnungselements und durch den Kontaktbereich des Öffnungselements der Be- und/oder Entladestation ausgebildeter Überlappungsbereich bei einer idealen Überlappung minimiert. Die "Abweichung von der idealen Endposition" soll insbesondere als eine, insbesondere räumliche und/oder rotatorische, Abweichung der durch den Positioniermechanismus eingestellten Positionierung von einer durch einen an den Positioniermechanismus anschließenden Endpositioniermechanismus eingestellten Endpositionierung verstanden werden.

Des Weiteren wird vorgeschlagen, dass die Positioniervorrichtung eine Steuer- und/oder Regeleinheit aufweist, welche dazu vorgesehen ist, die Positionierung des Wafer-Transportbehältnisses mittels des Positioniermechanismus, insbesondere zumindest in einer zu der Be- und/oder Entladeposition parallelen Ebene, zu steuern und/oder zu regeln. Dadurch kann vorteilhaft eine hohe Präzision der mittels der Positioniervorrichtung erreichbaren Positionierung ermöglicht werden. Zudem kann vorteilhaft eine Positionierung flexibel auf eine Ausgangspositionierung bzw. eine Grobpositionierung, angepasst werden. Außerdem kann vorteilhaft eine Positionierung flexibel auf unterschiedliche, insbesondere unterschiedlich geformte, Wafer-Transportbehältnisse angepasst werden. Insbesondere ist die Steuer- und/oder Regeleinheit zumindest dazu vorgesehen, ein Magnetfeld des Positioniermechanismus zu steuern. Insbesondere ist die Steuer- und/oder Regeleinheit zumindest dazu vorgesehen, ein elektrostatisches Feld des Positioniermechanismus zu steuern. Insbesondere ist die Steuer- und/oder Regeleinheit zumindest dazu vorgesehen, ein Strömungsfeld eines strömenden Fluids des Positioniermechanismus zu steuern. Insbesondere ist die Steuer- und/oder Regeleinheit zumindest dazu vorgesehen, eine Stärke, eine Ausrichtung, eine Lage und/oder eine Position des Magnetfelds, des elektrostatischen Felds und/oder des Strömungsfelds zu steuern und/oder zu regeln.

Außerdem wird vorgeschlagen, dass der Positioniermechanismus zumindest ein Positionierelement umfasst, welches dazu vorgesehen ist, zumindest ein, insbesondere berührungslos übertragbares, Positionierkraftfeld zu erzeugen. Dadurch können vorteilhafte Eigenschaften hinsichtlich einer Positionierung eines Wafer-Transportbehältnisses auf einer Be- und/oder Entladestation für Wafer aus dem Wafer-Transportbehältnis erreicht werden. Insbesondere kann vorteilhaft eine Partikelgeneration bei einem Koppelvorgang mittels des Positioniermechanismus reduziert und/oder vermieden werden, insbesondere indem eine, insbesondere zu einer Partikelgeneration führende, äußere Reibung zwischen Festkörpern, insbesondere zwischen dem Wafer-Transportbehältnis und der Be- und/oder Entladestation, vermieden werden kann. Das Positionierelement ist insbesondere dazu vorgesehen, ein Magnetfeld, ein elektrisches, insbesondere ein elektrostatisches, Feld und/oder ein Strömungsfeld zu erzeugen. Das Positionierelement umfasst insbesondere zumindest eine magnetische Spule, zumindest eine elektrisch aufladbare, vorzugsweise elektrisch isolierbare, Leiterfläche und/oder zumindest eine Düse für ein Fluid. Das Positionierelement ist insbesondere zumindest teilweise einstückig mit der Be- und/oder Entladestation, insbesondere dem Öffnungselement der Be- und/oder Entladestation, und/oder mit dem Wafer-Transportbehältnis ausgebildet. Das Positionierkraftfeld ist insbesondere als ein magnetisches Feld, als ein elektrisches Feld, als ein elektrostatisches Feld und/oder als ein Fluidströmungsfeld, insbesondere ein Gasströmungsfeld, ausgebildet. Es ist denkbar, dass sich eine Mehrzahl an gleichartigen und/oder verschiedenartigen Positionierkraftfeldern eines einzelnen Positionierelements und/oder einer Mehrzahl an Positionierelementen überlagern. Insbesondere ist vorstellbar, dass zumindest ein Positionierkraftfeld des Positionierelements steuer- und/oder regelbar ausgebildet ist. Zudem ist vorstellbar, dass zumindest ein Positionierkraftfeld des Positionierelements statisch ausgebildet ist. Unter "einstückig" soll insbesondere zumindest stoffschlüssig verbunden verstanden werden, beispielsweise durch einen Schweißprozess, einen Klebeprozess, einen Anspritzprozess und/oder einen anderen, dem Fachmann als sinnvoll erscheinenden Prozess, und/oder vorteilhaft in einem Stück geformt verstanden werden, wie beispielsweise durch eine Herstellung aus einem Guss und/oder durch eine Herstellung in einem Ein- oder Mehrkomponentenspritzverfahren und vorteilhaft aus einem einzelnen Rohling.

Weiterhin wird vorgeschlagen, dass der Positioniermechanismus zumindest ein weiteres Positionierelement, vorzugsweise zumindest zwei weitere, bevorzugt zumindest drei weitere und besonders bevorzugt mehr als drei weitere Positionierelemente umfasst, welche/s dazu vorgesehen ist/sind, zumindest ein weiteres Positionierkraftfeld, vorzugsweise zumindest zwei weitere, bevorzugt zumindest drei weitere und besonders bevorzugt mehr als drei weitere, insbesondere berührungslos übertragbare, Positionierkraftfelder zu erzeugen. Dadurch kann vorteilhaft eine besonders genaue Positionierung ermöglicht werden. Insbesondere kann dadurch eine besonders hohe Präzision der Steuerung und/oder der Regelung der Positionierung erreicht werden. Vorteilhaft können dadurch unterschiedliche und/oder gleichartige Kraftfelder, insbesondere zu einer Erhöhung einer Steuerungspräzision, überlagert werden. Insbesondere kann ein weiteres Positionierelement als ein zu dem Positionierelement korrespondierendes Positionierelement ausgebildet sein. Beispielsweise ist vorstellbar, dass ein an der Be- und/oder Entladestation angeordnetes Positionierelement ein steuer- und/oder regelbares Magnetfeld mittels einer magnetischen Spule erzeugt, welches dazu vorgesehen ist, mit einem statischen Magnetfeld eines als Permanentmagneten ausgebildeten korrespondierenden Positionierelements, welches an einem Wafer-Transportbehältnis angeordnet ist, wechselzuwi rken.

Wenn der Positioniermechanismus, insbesondere das Positionierelement, dazu vorgesehen ist, zu der Positionierung zumindest eine, insbesondere repulsiv auf das Wafer-Transportbehältnis wirkende, abstoßende Kraft zu erzeugen, kann vorteilhaft ein Risiko eines unbeabsichtigten, partikelerzeugenden Kontakts eines durch den Positioniermechanismus zu positionierenden Objekts mit einem Positionierelement und/oder einem weiteren Objekt, beispielsweise durch eine Übersteuerung einer anziehenden Kraft, vermieden werden, wodurch vorteilhaft eine durch den Positioniermechanismus erzeugte Partikelzahl gering gehalten werden kann. Unter einer "abstoßenden Kraft" soll insbesondere eine Kraft verstanden werden, welche dazu vorgesehen ist, das Wafer-Transportbehältnis in eine Richtung auszulenken und/oder zu drücken, welche von dem die abstoßende Kraft erzeugenden Positionierelement wegweisend ausgerichtet ist.

Zusätzlich wird vorgeschlagen, dass zumindest ein Positionierelement zumindest dazu vorgesehen ist, zumindest ein als ein Magnetfeld ausgebildetes Positionierkraftfeld zu erzeugen. Dadurch kann vorteilhaft eine effektive berührungslose Kraftübertragung erreicht werden, wodurch insbesondere eine Partikelgeneration reduziert und/oder vermieden werden kann. Zudem ist/sind insbesondere ein Magnetfeld und/oder eine Kombination von Magnetfeldern einfach und/oder präzise steuer- und/oder regelbar sowie insbesondere auf besonders kleinem Raum variierbar.

Wenn zumindest ein, insbesondere korrespondierendes, Positionierelement zumindest teilweise als ein Permanentmagnet ausgebildet ist, kann vorteilhaft ein Positionierkraftfeld stromlos erzeugt werden. Ein als Permanentmagnet ausgebildetes Positionierelement verstärkt vorteilhaft eine Reaktion auf eine durch ein steuerbares Positionierelement hervorgerufene Änderung eines Positionierkraftfelds, welches mit dem Positionierkraftfeld des als Permanentmagnet ausgebildeten Positionierelements überlagert ist, wodurch vorteilhaft eine zu einer Ansteuerung einer Positionierung benötigte Leistung gering gehalten werden kann. Das als Permanentmagnet ausgebildete Positionierelement ist insbesondere an dem Wafer-Transportbehältnis angeordnet.

Wenn zumindest ein Positionierelement zumindest teilweise einstückig mit dem Wafer-Transportbehältnis ausgebildet ist, kann vorteilhaft eine einfache Konstruktion des Positioniermechanismus ermöglicht werden. Insbesondere ist das einstückig mit dem Wafer-Transportbehältnis ausgebildete Positionierelement als ein Permanentmagnet und/oder als ein dia-, para- und/oder ferromagnetisches Element ausgebildet. Das Positionierelement ist insbesondere zumindest teilweise aus einem dia-, para- und/oder ferromagnetischen Material ausgebildet. Insbesondere ist das einstückig mit dem Wafer-Transportbehältnis ausgebildete Positionierelement einstückig mit dem Wafer-Transportbehältnis-Öffnungselement und/oder mit dem Grundkörper des Wafer-Transportbehältnisses ausgebildet. Vorzugsweise umfasst das Wafer-Transportbehältnis eine Mehrzahl an Positionierelementen, von denen vorzugsweise zumindest ein Teil zumindest teilweise einstückig mit dem Wafer-Transportbehältnis ausgebildet ist. Zudem ist vorstellbar, dass eine Außenhülle des Wafer-Transportbehältnisses ein, insbesondere korrespondierendes, Positionierelement ausbildet.

Zudem wird vorgeschlagen, dass zumindest ein Positionierelement unverlierbar mit der Be- und/oder Entladestation verbunden ist. Dadurch kann vorteilhaft eine Positionierung relativ zu der Be- und/oder Entladestation, insbesondere einer Oberfläche der Be- und/oder Entladestation, ermöglicht werden. Unter der Wendung "unverlierbar verbunden" soll insbesondere verstanden werden, dass das Positionierelement und die Be- und/oder Entladestation in jedem vorgesehenen Betriebszustand miteinander verbunden sind. Vorteilhaft sind das Positionierelement und die Be- und/oder Entladestation nur mittels Werkzeug, nur durch Zerstörung und/oder nur unter Funktionsverlust voneinander trennbar. Vorzugsweise ist das Positionierelement mit einem unbeweglichen Bauteil der Be- und/oder Entladestation unverlierbar verbunden. Alternativ kann das Positionierelement auch mit einem beweglich gelagerten Bauteil der Be- und/oder Entladestation, beispielsweise dem Öffnungselement der Be- und/oder Entladestation, unverlierbar verbunden sein.

Wenn das Positionierelement relativ zu der Be- und/oder Entladestation beweglich gelagert ist, kann vorteilhaft eine besonders große Variabilität des Positionierkraftfelds ermöglicht werden, wodurch insbesondere eine besonders präzise Positionierung des Wafer-Transportbehältnisses ermöglicht werden kann. Insbesondere ist vorstellbar, dass das Positionierelement zumindest teilweise dazu vorgesehen ist, einer Vertikalbewegung des Wafer-Transportbehältnisses in Richtung der Be- und/oder Entladeposition bzw. der Oberfläche des Öffnungselements der Be- und/oder Entladeeinheit, beispielsweise bei einem Ankoppel- und/oder bei einem Abkoppelvorgang, zu folgen. Unter der Wendung "beweglich gelagert" soll insbesondere zumindest translatorisch gelagert, zumindest schwenkbar gelagert und/oder zumindest rotatorisch gelagert verstanden werden. Vorzugsweise ist das Positionierelement zumindest relativ zu der Oberfläche der Be- und/oder Entladestation und/oder zu dem Öffnungselement der Be- und/oder Entladestation beweglich gelagert. Insbesondere ist das Positionierelement um zumindest eine, vorzugsweise zumindest zwei Achsen schwenkbar gelagert, wobei vorzugsweise zumindest eine Achse senkrecht oder waagrecht relativ zu der Oberfläche der Be- und/oder Entladestation ausgerichtet ist. Insbesondere ist das Positionierelement in zumindest eine, vorzugsweise zumindest zwei, bevorzugt zumindest drei und besonders bevorzugt zumindest vier Raumrichtungen translatorisch beweglich gelagert, wobei die Raumrichtungen zumindest eine, vorzugsweise zumindest zwei, parallel zu der Oberfläche der Be- und/oder Entladestation verlaufende Richtung/en, zumindest eine senkrecht zu der Oberfläche der Be- und/oder Entladestation verlaufende und/oder zumindest eine in einer Umfangsrichtung auf einen Zylindermantel eines gedachten, senkrecht von der Oberfläche der Be- und/oder Entladestation wegweisenden Zylinders verlaufende Richtung umfassen.

Zudem wird vorgeschlagen, dass zumindest ein, insbesondere ein weiteres, Positionierelement dazu vorgesehen ist, zumindest ein als ein elektrisches Feld, insbesondere ein elektrostatisches Feld, ausgebildetes Positionierkraftfeld zu erzeugen. Dadurch kann vorteilhaft eine effektive berührungslose Kraftübertragung erreicht werden, wodurch insbesondere eine Partikelgeneration reduziert und/oder vermieden werden kann.

Außerdem wird vorgeschlagen, dass zumindest ein, insbesondere zusätzliches weiteres, Positionierelement dazu vorgesehen ist, zumindest ein als ein Strömungsfeld eines strömenden Gases ausgebildetes Positionierkraftfeld zu erzeugen. Dadurch kann vorteilhaft eine effektive berührungslose Kraftübertragung erreicht werden, wodurch insbesondere eine Partikelgeneration reduziert und/oder vermieden werden kann.

Weiterhin wird vorgeschlagen, dass der Positioniermechanismus zumindest eine Düse zu einer Erzeugung eines zumindest teilweise gerichteten Gasstroms aufweist, wobei der Gasstrom, insbesondere ein mittlerer Gesamtgasstrom eines durch die Düse erzeugten Strömungsfeldes, zumindest im Wesentlichen parallel zu der Kopplungsrichtung der Positioniervorrichtung ausgerichtet ist. Dadurch kann vorteilhaft eine Führung des Wafer-Transportbehältnisses in Kopplungsrichtung ermöglicht werden. Insbesondere ist die Düse in der Oberfläche der Be- und/oder Entladestation angeordnet. Insbesondere ist die Düse in einer Umfangsrichtung rund um das Öffnungselement der Be- und/oder Entladestation angeordnet. Vorzugsweise ist die Düse dazu vorgesehen, einen Luftvorhang rund um das Öffnungselement der Be- und/oder Entladestation zu erzeugen. Durch eine derartige Ausrichtung des Gasstroms senkrecht zu der Oberfläche der Be- und/oder Entladestation können vorteilhaft Partikel von der Oberfläche der Be- und/oder Entladestation ferngehalten werden. Die Düse ist insbesondere zu einer saugenden Funktionsweise vorgesehen. Alternativ kann die Düse auch zu einer blasenden Funktionsweise vorgesehen sein.

Wenn zumindest ein, insbesondere weiterer, Gasstrom des Positionierelements, insbesondere ein mittlerer Gesamtgasstrom des Strömungsfeldes, zumindest im Wesentlichen senkrecht zu einer Kopplungsrichtung der Positioniervorrichtung ausgerichtet ist, kann vorteilhaft eine berührungslose Positionierung des Wafer-Transportbehältnisses in einer Ebene parallel zu der Oberfläche der Be- und/oder Entladestation ermöglicht werden. Insbesondere weist das Positionierelement zumindest eine Düse auf, welche insbesondere dazu vorgesehen ist, eine Austrittsöffnung und/oder eine Eintrittsöffnung für strömendes Gas, insbesondere strömende Luft, bereitzustellen. Die Düse ist insbesondere beweglich ausgebildet. Insbesondere ist die Richtung des aus der Düse austretenden Gasstroms mittels der Steuer- und/oder Regeleinheit einstellbar. Die Düse des Positionierelements ist insbesondere zu einer blasenden Funktionsweise vorgesehen. Bei der blasenden Funktionsweise drückt der Gasstrom das Wafer-Transportbehältnis insbesondere in eine von dem Positionierelement, insbesondere der Düse, wegweisende Richtung. Alternativ kann die Düse auch zu einer saugenden Funktionsweise vorgesehen sein. Bei der saugenden Funktionsweise zieht der Gasstrom das Wafer-Transportbehältnis insbesondere in eine auf das Positionierelement, insbesondere die Düse, zuweisende Richtung.

Außerdem wird vorgeschlagen, dass die Positioniervorrichtung eine Kontrolleinheit zu einer, insbesondere dreidimensionalen, Positionskontrolle, insbesondere einer Echtzeit-Positionskontrolle, und/oder zu einer, vorzugsweise gesteuerten, Positionsregelung einer Ist-Position, des Wafer-Transportbehältnisses während des Koppelvorgangs aufweist. Dadurch kann vorteilhaft eine hohe Präzision der Positionierung erreicht werden, insbesondere indem eine Positionierung aktiv gesteuert und/oder geregelt werden kann. Zudem kann dadurch vorteilhaft eine Betriebssicherheit erhöht werden, insbesondere indem eine vorgenommene Positionierung des Wafer-Transportbehältnisses, insbesondere vor einem Öffnen des Wafer-Transportbehältnisses, überprüft werden kann. Insbesondere ist die Kontrolleinheit dazu vorgesehen, eine aktuelle Position des Wafer-Transportbehältnisses zu erfassen und gegebenenfalls zumindest ein Positionierelement zu einer Positionskorrektur, insbesondere mittels einer Variation des Positionierkraftfelds des Positionierelements und/oder mittels einer Variation einer räumlichen Position und/oder räumlichen Orientierung des Positionierelements, anzusteuern. Unter einer "dreidimensionalen Positionskontrolle" soll insbesondere zumindest eine Positionskontrolle einer räumlichen Position des Wafer-Transportbehältnisses innerhalb einer zu der Oberfläche der Be- und/oder Entladestation parallelen Ebene und/oder eine Positionskontrolle einer Rotationsposition des Wafer-Transportbehältnisses verstanden werden. Unter einer "Echtzeit-Positionskontrolle" soll insbesondere zumindest eine Positionskontrolle verstanden werden, mittels welcher eine durch die Kontrolleinheit detektierte räumliche und/oder rotatorische Ist-Position des Wafer-Transportbehältnisses direkt von der Steuer- und/oder Regeleinheit ausgelesen wird, woraufhin insbesondere eine räumliche und/oder rotatorische Soll-Position des Wafer-Transportbehältnisses durch die Steuer- und/oder Regeleinheit bestimmt wird und woraufhin insbesondere zumindest ein Steuer- und/oder Regelbefehl zu einer Positionskorrektur der Ist-Position des Wafer-Transportbehältnisses durch die Steuer- und/oder Regeleinheit an zumindest ein Positionierelement ausgegeben wird. Unter einer "Positionsregelung" soll insbesondere ein Vorgang verstanden werden, bei welchem eine durch die Kontrolleinheit erkannte Ist-Position des Wafer-Transportbehältnisses mittels einer Steuerung und/oder Regelung zumindest eines Positionierkraftfelds an eine vorgegebene Soll-Position des Wafer-Transportbehältnisses angenähert wird. Insbesondere bildet die Soll-Position des Wafer-Transportbehältnisses, insbesondere im gekoppelten Zustand des Wafer-Transportbehältnisses mit der Be- und/oder Entladestation, die ideale Be- und/oder Entladeposition und/oder eine Position, in welcher das Wafer-Transportbehältnis und die Be- und/oder Entladestation, insbesondere entlang der Kopplungsrichtung, ideal überlappen, aus.

Des Weiteren wird vorgeschlagen, dass die Kontrolleinheit zumindest eine Sensoreinheit aufweist, wobei die Sensoreinheit zumindest teilweise einstückig mit dem Positioniermechanismus, insbesondere dem Positionierelement, ausgebildet ist. Dadurch kann vorteilhaft eine Komplexität reduziert werden, insbesondere indem einem einzelnen Bauteil vorteilhaft mehrere Aufgaben zugeordnet werden können. Darunter, dass zwei Einheiten "teilweise einstückig" ausgebildet sind, soll insbesondere verstanden werden, dass die Einheiten zumindest ein, insbesondere zumindest zwei, vorteilhaft zumindest drei gemeinsame Elemente aufweisen, die Bestandteil, insbesondere funktionell wichtiger Bestandteil, beider Einheiten sind. Die Sensoreinheit weist insbesondere zumindest ein Sensorelement auf. Das Sensorelement ist insbesondere zumindest dazu vorgesehen, einen Parameter der Positioniervorrichtung, des Wafer-Transportbehältnisses und/oder der Be- und/oder Entladestation zu sensieren. Der Parameter der Positioniervorrichtung kann insbesondere eine rotatorische Position und/oder Bewegung des Wafer-Transportbehältnisses, eine räumliche Position und/oder Bewegung des Wafer-Transportbehältnisses und/oder einen Abstand und/oder eine Abstandsänderung zwischen dem Wafer-Transportbehältnis und dem Sensorelement umfassen. Vorzugsweise ist das Sensorelement zumindest dazu vorgesehen, eine räumliche Position und/oder Bewegung des Wafer-Transportbehältnisses relativ zu der Oberfläche der Be- und/oder Entladestation zu sensieren. Insbesondere ist das Sensorelement als zumindest eine Magnetspule ausgebildet, welche vorzugsweise dazu vorgesehen ist, ein als ein Magnetfeld ausgebildetes Positionierkraftfeld zu erzeugen. Insbesondere ist das Sensorelement dazu vorgesehen, vorzugsweise gleichzeitig mit einer Erzeugung eines Positionierkraftfelds, den Parameter der Positioniervorrichtung anhand von Messungen von durch Magnetfelder, insbesondere durch überlagerte Positionierkraftfelder, insbesondere in der Leiterbahn der Magnetspule, induzierten Gegenströmen zu sensieren. Alternativ oder zusätzlich kann die Sensoreinheit zumindest ein Sensorelement aufweisen, welches getrennt von dem Positioniermechanismus, insbesondere dem Positionierelement, ausgebildet ist. Insbesondere kann die Sensoreinheit zumindest ein als ein optischer Sensor, beispielsweise eine Kamera und/oder eine Lichtschranke, ausgebildetes Sensorelement umfassen.

Wenn die Positioniervorrichtung einen Endpositioniermechanismus aufweist, wobei der Positioniermechanismus zumindest teilweise getrennt von dem Endpositioniermechanismus ausgebildet ist, können vorteilhafte Eigenschaften hinsichtlich einer Positionierung eines Wafer-Transportbehältnisses auf einer Be- und/oder Entladestation für Wafer aus dem Wafer-Transportbehältnis erreicht werden. Insbesondere kann vorteilhaft eine Partikelgeneration bei einem Koppelvorgang mittels des Positioniermechanismus reduziert werden, insbesondere indem eine, insbesondere zu einer Partikelgeneration führende, äußere Reibung zwischen Festkörpern, insbesondere zwischen dem Wafer-Transportbehältnis und der Be- und/oder Entladestation, während der Positionierung, insbesondere der Vorpositionierung, mittels des Positioniermechanismus vermieden und vorzugsweise auf den Endpositioniermechanismus beschränkt werden kann. Insbesondere kann durch eine präzise Positionierung im Vorfeld der Endpositionierung eine Reibung während der Endpositionierung vorteilhaft minimiert werden. Der Endpositioniermechanismus umfasst insbesondere eine Führungseinheit, welche insbesondere dazu vorgesehen ist, eine Endpositionierung des Wafer-Transportbehältnisses in der idealen Be- und/oder Entladeposition mittels eines Führens eines Führungselements der Führungseinheit in einer Führungsschiene der Führungseinheit festzulegen. Vorzugsweise umfasst die Führungseinheit eine Mehrzahl von Führungselementen und Führungsschienen. Insbesondere sind die Führungselemente und/oder Führungsschienen auf einer, insbesondere an einer Außenseite des Wafer-Transportbehältnisses angeordneten, Oberfläche des Wafer-Transportbehältnis-Öffnungselements, auf der, insbesondere an einer Außenseite der Be- und/oder Entladestation angeordneten, Oberfläche der Be- und/oder Entladestation und/oder des Öffnungselements der Be- und/oder Entladestation angeordnet. Zudem weist die Positioniervorrichtung einen Grobpositioniermechanismus auf, welcher zumindest teilweise getrennt von dem Positioniermechanismus und/oder dem Endpositioniermechanismus ausgebildet ist. Insbesondere umfasst der Grobpositioniermechanismus eine Positionierung mittels des Wafer-Transportbehältnis-Transportsystems der Wafer-Fabrikationsanlage, welche insbesondere das Wafer-Transportbehältnis mittels Seilen und/oder Kabeln hält und grob relativ zu der Be- und/oder Entladestation positioniert.

Zudem wird ein Be- und/oder Entladesystem zu einem Be- und/oder Entladen von Wafern aus einem Wafer-Transportbehältnis, mit dem Wafer-Transportbehältnis, mit der Be- und/oder Entladestation und mit der Positioniervorrichtung, insbesondere der Wafer-Transportbehältnis-Positioniervorrichtung, vorgeschlagen. Durch das erfindungsgemäße Be- und/oder Entladesystem können vorteilhafte Eigenschaften hinsichtlich einer Positionierung eines Wafer-Transportbehältnisses auf einer Be- und/oder Entladestation für Wafer aus dem Wafer-Transportbehältnis erreicht werden. Insbesondere kann vorteilhaft eine Partikelgeneration bei einer Positionierung des Wafer-Transportbehältnisses auf der Be- und/oder Entladestation reduziert werden.

Außerdem wird ein Verfahren zum Betrieb der Positioniervorrichtung, insbesondere der Wafer-Transportbehältnis-Positioniervorrichtung, und/oder des Be-und/oder Entladesystems vorgeschlagen, wobei bei dem Koppelvorgang zwischen einem Wafer-Transportbehältnis und der Be- und/oder Entladestation das Wafer-Transportbehältnis berührungslos relativ zu der Be- und/oder Entladestation positioniert wird. Dadurch kann vorteilhaft eine Partikelgeneration bei der Positionierung gering gehalten werden.

Ferner wird vorgeschlagen, dass das Wafer-Transportbehältnis, insbesondere mittels der Positioniervorrichtung im Anschluss an eine externe Grobpositionierung, positioniert wird. Dadurch kann vorteilhaft eine hohe Effektivität der Positionierung erreicht werden.

Die erfindungsgemäße Positioniervorrichtung, insbesondere die Wafer-Transportbehältnis-Positioniervorrichtung, das erfindungsgemäße Be- und/oder Entladesystem und/oder das erfindungsgemäße Verfahren soll/sollen hierbei nicht auf die oben beschriebene Anwendung und Ausführungsform beschränkt sein. Insbesondere kann die erfindungsgemäße Positioniervorrichtung, insbesondere die Wafer-Transportbehältnis-Positioniervorrichtung, das erfindungsgemäße Be- und/oder Entladesystem und/oder das erfindungsgemäße Verfahren, zu einer Erfüllung einer hierin beschriebenen Funktionsweise eine von einer hierin genannten Anzahl von einzelnen Elementen, Bauteilen, Einheiten und Verfahrensschritten abweichende Anzahl aufweisen.

### Zeichnungen

Weitere Vorteile ergeben sich aus der folgenden Zeichnungsbeschreibung. In den Zeichnungen sind vier Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine schematische Darstellung eines Be- und/oder Entladesystems mit einem Wafer-Transportbehältnis, mit einer Be- und/oder Entladestation und mit einer Positioniervorrichtung,
- Fig. 2: ein Ablaufdiagramm eines Verfahrens zum Betrieb der Positioniervorrichtung,
- Fig. 3: eine schematische Darstellung eines alternativen Be- und/oder Entladesystems mit einer alternativen Positioniervorrichtung,
- Fig. 4: eine schematische Darstellung eines alternativen Positionierelements der alternativen Positioniervorrichtung,
- Fig. 5: eine schematische Darstellung eines weiteren alternativen Positionierelements einer weiteren alternativen Positioniervorrichtung und
- Fig. 6: eine schematische Draufsicht auf eine zusätzliche alternative Be- und/oder Entladestation mit einem zusätzlichen alternativen Positionierelement einer zusätzlichen weiteren alternativen Positioniervorrichtung.

### Beschreibung der Ausführungsbeispiele

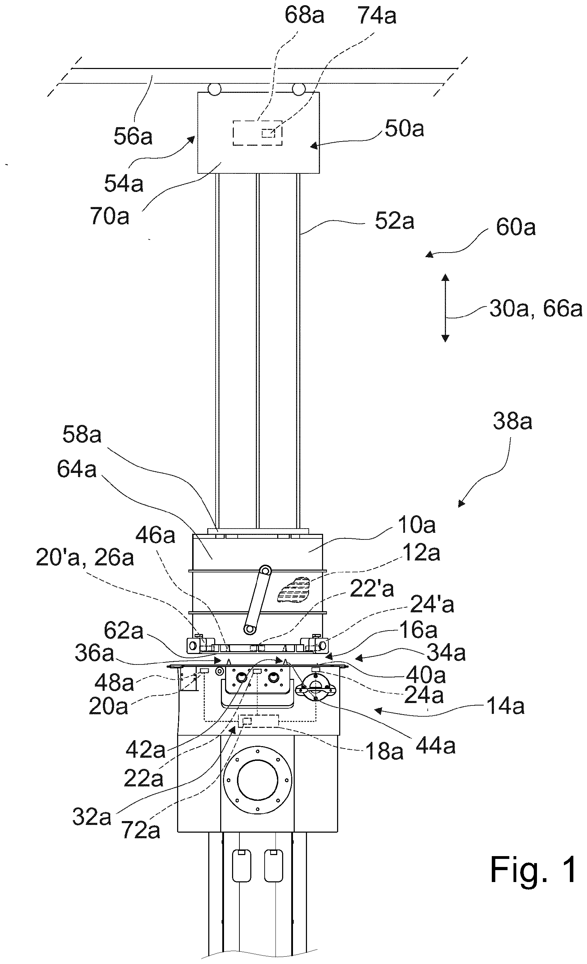

Fig. 1 zeigt ein Be- und/oder Entladesystem 38a. Das Be- und/oder Entladesystem 38a umfasst ein Wafer-Transportbehältnis 10a. Das Wafer-Transportbehältnis 10a ist zu einem Transport und/oder einer Lagerung von Wafern 12a vorgesehen. Das Be- und/oder Entladesystem 38a ist zu einem Be- und/oder Entladen von Wafern 12a aus dem Wafer-Transportbehältnis 10a vorgesehen. Das Wafer-Transportbehältnis 10a weist ein Wafer-Transportbehältnis-Öffnungselement 62a auf. Das Wafer-Transportbehältnis 10a weist einen Grundkörper 64a auf. Das Wafer-Transportbehältnis-Öffnungselement 62a ist zu einem Verschließen einer Öffnung des Grundkörpers 64a des Wafer-Transportbehältnisses 10a vorgesehen. Das Wafer-Transportbehältnis-Öffnungselement 62a ist von dem Grundkörper 64a des Wafer- Transportbehältnisses 10a abnehmbar ausgebildet.

Das Be- und/oder Entladesystem 38a weist eine Be- und/oder Entladestation 14a auf. Die Be- und/oder Entladestation 14a ist zu einem Be- und/oder Entladen von Wafern 12a aus dem Wafer-Transportbehältnis 10a vorgesehen. Zu einem Be- und/oder Entladen von Wafern 12a öffnet die Be- und/oder Entladestation 14a das Wafer-Transportbehältnis 10a durch ein Lösen des Wafer-Transportbehältnis-Öffnungselements 62a von dem Grundkörper 64a des Wafer-Transportbehältnisses 10a. Die Be- und/oder Entladestation 14a bewegt zu einem Öffnen des Wafer-Transportbehältnisses 10a das Wafer-Transportbehältnis-Öffnungselement 62a in eine Be- und/oder Entladerichtung 66a. Die Be- und/oder Entladerichtung 66a verläuft zumindest im Wesentlichen senkrecht zu einer Haupterstreckungsebene des Wafer-Transportbehältnis-Öffnungselements 62a. Das Wafer-Transportbehältnis-Öffnungselement 62a wird bei einem Öffnen mittels der Be- und/oder Entladestation 14a in einen Innenraum der Be- und/oder Entladestation 14a abgesenkt. Bei einem Be- und/oder Entladen des Wafer-Transportbehältnisses 10a ist ein Innenraum des Grundkörpers 64a des Wafer-Transportbehältnisses 10a vakuumdicht mit dem Innenraum der Be- und/oder Entladestation 14a verbunden. Die Be- und/oder Entladestation 14a ist zu einem Weitertransport aus dem Wafer-Transportbehältnis 10a entladener Wafer 12a an zumindest ein Wafer-Prozessmodul (nicht gezeigt) vorgesehen.

Die Be- und/oder Entladestation 14a weist eine Oberfläche 40a auf, welche zu einem kontaktierenden Aufsetzen des Wafer-Transportbehältnisses 10a vorgesehen ist. Die Be- und/oder Entladestation 14a weist eine Be- und/oder Entladeposition auf. Die Be- und/oder Entladeposition ist als die Position ausgebildet, in welcher das Wafer-Transportbehältnis 10a auf der Be- und/oder Entladestation 14a abgesetzt und, unter Ausbildung einer vakuumdichten Verbindung zwischen dem Inneren der Be- und/oder Entladestation 14a und dem Inneren des Wafer-Transportbehältnisses 10a, be- und/oder entladen werden kann. Die Be- und/oder Entladeposition ist auf der Oberfläche 40a der Be- und/oder Entladestation 14a angeordnet. In der in Fig. 1 gezeigten Darstellung befindet sich das Be- und/oder Entladesystem 38a in einem ungekoppelten Zustand. Das Wafer-Transportbehältnis 10a ist frei von einem Kontakt mit der Be- und/oder Entladestation 14a. Das Wafer-Transportbehältnis 10a befindet sich in einem Nahbereich der Be- und/oder Entladestation 14a.

Das Be- und/oder Entladesystem 38a weist ein Wafer-Transportbehältnis-Transportsystem 50a auf. Das Wafer-Transportbehältnis-Transportsystem 50a ist zu einem Transport von Wafer-Transportbehältnissen 10a zwischen verschiedenen Be- und/oder Entladesystemen 38a und/oder weiteren Einrichtungen einer Wafer-Fabrikationsanlage vorgesehen. Das Wafer-Transportbehältnis-Transportsystem 50a ist als ein reinraumtaugliches Overhead Hoist Transport (OHT) System ausgebildet. Alternativ kann das Wafer-Transportbehältnis-Transportsystem 50a auch als eine andere Art von Transportsystem für Wafer-Transportbehältnisse 10a ausgebildet sein. Beispielsweise könnte ein System von selbst fliegenden Drohnen dazu vorgesehen sein, die Wafer-Transportbehältnisse 10a zu der Be- und/oder Entladestation 14a hin oder von der Be- und/oder Entladestation 14a weg zu transportieren. Das Wafer-Transportbehältnis-Transportsystem 50a weist ein Schienensystem 56a auf. Das Schienensystem 56a umfasst zumindest eine Schiene, welche dazu vorgesehen ist, einen Transportpfad vorzugeben.

Das Wafer-Transportbehältnis-Transportsystem 50a weist einen Transportschlitten 54a auf. Der Transportschlitten 54a ist dazu vorgesehen, entlang von Schienen des Schienensystems 56a fortbewegt zu werden bzw. sich fortzubewegen. Der Transportschlitten 54a weist einen Grundkörper 70a auf. Der Transportschlitten 54a weist eine Halterung 58a auf. Die Halterung 58a ist dazu vorgesehen, das Wafer-Transportbehältnis 10a aufzunehmen. Die Halterung 58a ist dazu vorgesehen, das Wafer-Transportbehältnis 10a bei einem Transport mittels des Transportschlittens 54a, bei einer Grobpositionierung, bei einer Positionierung, bei einer Vorpositionierung und/oder bei einer Endpositionierung festzuhalten. Die Halterung 58a ist dazu vorgesehen, das Wafer-Transportbehältnis 10a lösbar zu haltern. Der Transportschlitten 54a weist eine Mehrzahl von Halteelementen 52a auf. Die Halteelemente 52a sind länglich ausgebildet. Die Halteelemente 52a sind biegeschlaff ausgebildet. Die Halteelemente 52a sind als Kabel und/oder Seile ausgebildet. Die Halteelemente 52a bilden eine Verbindung zwischen der Halterung 58a und dem Grundkörper 70a des Transportschlittens 54a aus. Ein Abstand zwischen dem Grundkörper 70a des Transportschlittens 54a und der Halterung 58a ist variabel. Zu einer Variation des Abstands zwischen dem Grundkörper 70a des Transportschlittens 54a und der Halterung 58a können die Halteelemente 52a aufgerollt werden. Der Transportschlitten 54a bildet einen Grobpositioniermechanismus 60a für das Wafer-Transportbehältnis 10a aus. Der Grobpositioniermechanismus 60a ist zu einer groben Positionierung des Wafer-Transportbehältnisses 10a relativ zu der Be- und/oder Entladestation 14a vorgesehen.

Der Transportschlitten 54a weist eine Steuereinheit 68a auf. Die Steuereinheit 68a des Transportschlittens 54a ist zu einer Steuerung und/oder einer Regelung der Halterung 58a, der Halteelemente 52a, insbesondere der Länge der Halteelemente 52a, vorgesehen. Die Steuereinheit 68a des Transportschlittens 54a ist zu einer Steuerung und/oder einer Regelung des Grobpositioniermechanismus 60a vorgesehen. Die Steuereinheit 68a des Transportschlittens 54a ist zu einer Steuerung und/oder einer Regelung der Bewegung des Transportschlittens 54a entlang des Schienensystems 56a vorgesehen. Die Steuereinheit 68a des Transportschlittens 54a weist ein Kommunikationsmodul 74a auf. Das Kommunikationsmodul 74a der Steuereinheit 68a des Transportschlittens 54a ist dazu vorgesehen, Steuer- und/oder Regelbefehle zu einer Steuerung und/oder Regelung des Transportschlittens 54a, der Halterung 58a und/oder der Halteelemente 52a zu empfangen. Das Kommunikationsmodul 74a der Steuereinheit 68a des Transportschlittens 54a ist dazu vorgesehen, Steuer- und/oder Regelbefehle der Steuereinheit 68a des Transportschlittens 54a an eine weitere Steuereinheit, beispielsweise eines weiteren Transportschlittens und/oder einer Be- und/oder Entladestation 14a, auszusenden.

Das Be- und/oder Entladesystem 38a weist eine Positioniervorrichtung auf. Die Positioniervorrichtung bildet eine Wafer-Transportbehältnis-Positioniervorrichtung aus. Die Positioniervorrichtung ist zu einer Positionierung des Wafer-Transportbehältnisses 10a in der Be- und/oder Entladeposition vorgesehen. Die Positioniervorrichtung ist zu einer Vorpositionierung des Wafer-Transportbehältnisses 10a in der Be- und/oder Entladeposition vorgesehen. Das Be- und/oder Entladesystem 38a weist einen Positioniermechanismus 16a auf. Der Positioniermechanismus 16a ist zu einer berührungslosen Positionierung des Wafer-Transportbehältnisses 10a bei einem Koppelvorgang des Wafer-Transportbehältnisses 10a mit der Be- und/oder Entladestation 14a vorgesehen. Der Positioniermechanismus 16a ist dazu vorgesehen, zu der Positionierung eine abstoßende und/oder eine anziehende Kraft zu erzeugen. Der Positioniermechanismus 16a ist getrennt von dem Grobpositioniermechanismus 60a ausgebildet. Der Positioniermechanismus 16a ist unabhängig von dem Wafer-Transportbehältnis-Transportsystem 50a, insbesondere unabhängig von einer Bewegung des Wafer-Transportbehältnis-Transportsystems 50a, ausgebildet. Der Positioniermechanismus 16a ist unabhängig von den Halteelementen 52a ausgebildet.

Der Positioniermechanismus 16a ist zu einer Nahbereichspositionierung des Wafer-Transportbehältnisses 10a in der Be- und/oder Entladeposition vorgesehen. Der Positioniermechanismus 16a ist zu einer Positionierung des Wafer-Transportbehältnisses in einer horizontalen Ebene vorgesehen. Die horizontale Ebene liegt senkrecht zu einer Kopplungsrichtung 30a. Der Positioniermechanismus 16a ist dazu vorgesehen, das Wafer-Transportbehältnis 10a so zu positionieren, dass eine Abweichung von einer idealen Be- und/oder Entladeposition höchstens 3 mm beträgt. Die Positioniervorrichtung weist eine Steuer- und/oder Regeleinheit 18a auf. Die Steuer- und/oder Regeleinheit 18a ist dazu vorgesehen, die Positionierung des Wafer-Transportbehältnisses 10a mittels des Positioniermechanismus 16a zu steuern und/oder zu regeln. Die Steuer- und/oder Regeleinheit 18a ist der Be- und/oder Entladestation 14a zugeordnet. Die Steuer- und/oder Regeleinheit 18a des Positioniermechanismus 16a weist ein Kommunikationsmodul 72a auf. Das Kommunikationsmodul 72a der Steuer- und/oder Regeleinheit 18a des Positioniermechanismus 16a ist dazu vorgesehen, Steuer- und/oder Regelbefehle zu einer Steuerung des Positioniervorgangs des Wafer-Transportbehältnisses 10a zu empfangen. Das Kommunikationsmodul 72a der Steuer und/oder Regeleinheit 18a des Positioniermechanismus 16a ist dazu vorgesehen, Steuer- und/oder Regelbefehle der Steuer- und/oder Regeleinheit 18a des Positioniermechanismus 16a an eine weitere Steuereinheit, beispielsweise eines Transportschlittens 54a, auszusenden.

Die Positioniervorrichtung weist einen Endpositioniermechanismus 36a auf. Der Endpositioniermechanismus 36a ist getrennt von dem Positioniermechanismus 16a ausgebildet. Der Endpositioniermechanismus 36a ist berührend ausgebildet. Das Be- und/oder Entladesystem 38a weist eine Führungseinheit 42a auf. Die Führungseinheit 42a ist ein Hauptfunktionsbestandteil des Endpositioniermechanismus 36a. Die Führungseinheit 42a weist ein Führungselement 44a auf. Das Führungselement 44a ist als ein bolzenartiger Vorsprung ausgebildet. Das Führungselement 44a ist als ein Pin ausgebildet. Das Führungselement 44a ist zu seinem Ende hin verjüngend ausgebildet. Das Führungselement 44a ist auf der Oberfläche 40a der Be- und/oder Entladestation 14a angeordnet. Die Führungseinheit 42a weist eine Führungsschiene 46a auf. Die Führungsschiene 46a ist als eine Vertiefung ausgebildet. Die Führungsschiene 46a ist auf einer äußeren Oberfläche des Wafer-Transportbehältnis-Öffnungselements 62a angeordnet. Das Führungselement 44a ist dazu vorgesehen, bei einer Endpositionierung in die Führungsschiene 46a einzugreifen. Die Führungsschiene 46a weist eine zu dem Führungselement 44a komplementäre Außenform auf. Durch ein Entlanggleiten einer Oberfläche des Führungselements 44a an einer Oberfläche der Führungsschiene 46a richtet der Endpositioniermechanismus 36a mittels der Führungseinheit 42a das Wafer-Transportbehältnis 10a relativ zu der Be- und/oder Entladestation 14a aus.

Der Positioniermechanismus 16a umfasst Positionierelemente 20a, 20'a, 22a, 22'a, 24a, 24'a. Die Positionierelemente 20a, 20'a, 22a, 22'a, 24a, 24'a sind dazu vorgesehen, jeweils ein Positionierkraftfeld zu erzeugen. Die Positionierelemente 20a, 20'a, 22a, 22'a, 24a, 24'a sind dazu vorgesehen, ein als ein Magnetfeld ausgebildetes Positionierkraftfeld zu erzeugen. Alternativ oder zusätzlich können die Positionierelemente 20a, 20'a, 22a, 22'a, 24a, 24'a dazu vorgesehen sein, ein als ein elektrisches Feld, insbesondere ein elektrostatisches Feld, ausgebildetes Positionierkraftfeld zu erzeugen. Drei Positionierelemente 20a, 22a, 24a sind an der Be- und/oder Entladestation 14a angeordnet. Die drei an der Be- und/oder Entladestation 14a angeordneten Positionierelemente 20a, 22a, 24a sind unverlierbar mit der Be- und/oder Entladestation 14a verbunden. Die drei an der Be- und/oder Entladestation 14a angeordneten Positionierelemente 20a, 22a, 24a sind aktiv steuer- und/oder regelbar. Die drei an der Be- und/oder Entladestation 14a angeordneten Positionierelemente 20a, 22a, 24a sind mit der Steuer- und/oder Regeleinheit 18a wirkverbunden. Die Steuer- und/oder Regeleinheit 18a ist dazu vorgesehen, die Positionierkraftfelder der aktiv steuer- und/oder regelbaren Positionierelemente 20a, 22a, 24a zu steuern und/oder zu regeln. Die Steuer- und/oder Regeleinheit 18a ist dazu vorgesehen, eine Stärke und/oder eine Richtung der Positionierkraftfelder zu steuern und/oder zu regeln. Jedes Positionierelement 20a, 22a, 24a ist einzeln ansteuerbar. Die Positionierkraftfelder der Positionierelemente 20a, 22a, 24a sind jeweils separat ansteuer- und/oder regelbar. Die Ansteuerung der Positionierelemente 20a, 22a, 24a ist über das Kommunikationsmodul 72a der Steuer- und/oder Regeleinheit 18a mit einer Steuerung des Wafer-Transportbehältnis-Transportsystems 50a koordinierbar.

Drei weitere Positionierelemente 20'a, 22'a, 24'a sind als korrespondierende Positionierelemente 20'a, 22'a, 24'a ausgebildet. Die weiteren Positionierelemente 20'a, 22'a, 24'a sind als passive Positionierelemente 20'a, 22'a, 24'a ausgebildet. Die weiteren Positionierelemente 20'a, 22'a, 24'a sind als Permanentmagneten 26a ausgebildet. Alternativ oder zusätzlich sind die weiteren Positionierelemente 20'a, 22'a, 24'a aus einem ferromagnetischen Material ausgebildet. Die weiteren Positionierelemente 20'a, 22'a, 24'a weisen ein statisches Positionierkraftfeld auf. Die statischen Positionierkraftfelder der weiteren Positionierelemente 20'a, 22'a, 24'a sind dazu vorgesehen, mit den aktiv regel- und/oder steuerbaren Positionierkraftfeldern der Positionierelemente 20a, 22a, 24a wechselzuwirken. Die weiteren Positionierelemente 20'a, 22'a, 24'a sind an dem Wafer-Transportbehältnis 10a angeordnet. Die weiteren Positionierelemente 20'a, 22'a, 24'a sind an dem Wafer-Transportbehältnis-Öffnungselement 62a angeordnet. Die weiteren Positionierelemente 20'a, 22'a, 24'a sind einstückig mit dem Wafer-Transportbehältnis 10a ausgebildet. Die weiteren Positionierelemente 20'a, 22'a, 24'a sind einstückig mit dem Wafer-Transportbehältnis-Öffnungselement 62a ausgebildet. Die Positionierkraftfelder der weiteren Positionierelemente 20'a, 22'a, 24'a sind unabhängig von einer Stromversorgung ausgebildet. Alternativ oder zusätzlich ist vorstellbar, dass aktive Positionierelemente 20a, 20'a, 22a, 22'a, 24a, 24'a dem Wafer-Transportbehältnis 10a zugeordnet sind und/oder dass passive Positionierelemente 20a, 20'a, 22a, 22'a, 24a, 24'a der Be- und/oder Entladestation 14a zugeordnet sind.

Die Positioniervorrichtung weist eine Kontrolleinheit 32a auf. Die Kontrolleinheit 32a ist zu einer Positionskontrolle und/oder zu einer Positionsregelung einer Ist-Position des Wafer-Transportbehältnisses 10a während des Koppelvorgangs vorgesehen. Die Kontrolleinheit 32a weist eine Sensoreinheit 34a auf. Die Sensoreinheit 34a ist einstückig mit dem Positioniermechanismus 16a ausgebildet. Die Sensoreinheit 34a weist ein Sensorelement 48a auf. Das Sensorelement 48a ist einstückig mit dem Positionierelement 20a, 20'a, 22a, 22'a, 24a, 24'a ausgebildet. Alternativ oder zusätzlich kann die Sensoreinheit 34a separat von den Positionierelementen 20a, 20'a, 22a, 22'a, 24a, 24'a ausgebildete Sensorelemente 48a aufweisen. Die Sensoreinheit 34a übermittelt Sensordaten von Sensorelementen 48a an die Steuer- und/oder Regeleinheit 18a. Die Steuer- und/oder Regeleinheit 18a ist dazu vorgesehen, eine Steuerung und/oder Regelung der Positionierkraftfelder der Positionierelemente 20a, 20'a, 22a, 22'a, 24a, 24'a in Abhängigkeit von Daten der Sensoreinheit 34a vorzunehmen. Die Steuer- und/oder Regeleinheit 18a ist dazu vorgesehen, anhand von Positionsdaten der Sensoreinheit 34a einen Abgleich der Ist-Position des Wafer-Transportbehältnisses 10a mit einer Soll-Position des Wafer-Transportbehältnisses 10a vorzunehmen und eine gesteuerte und/oder geregelte Positionierung des Wafer-Transportbehältnisses 10a in der Be- und/oder Entladeposition vorzunehmen.

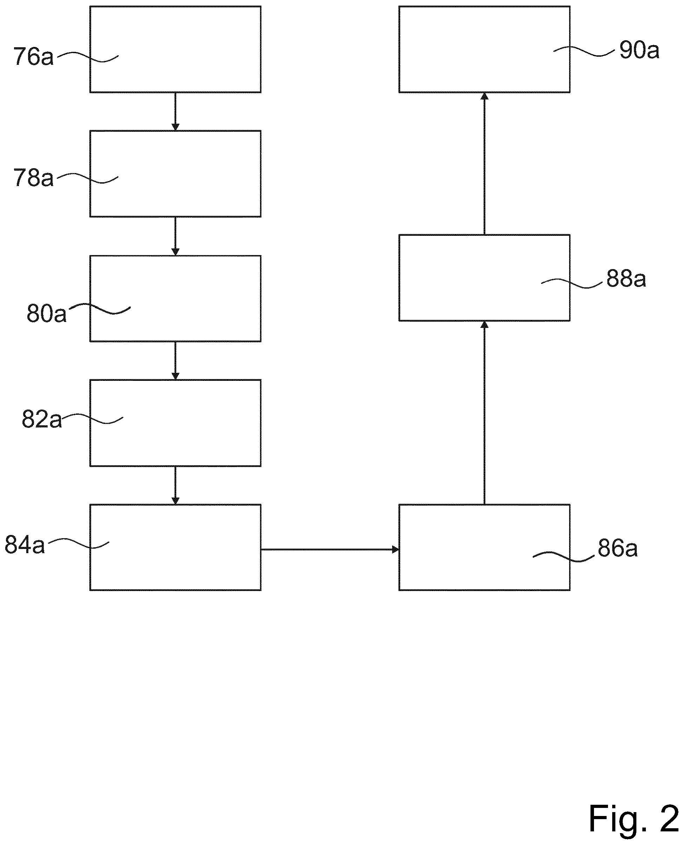

Fig. 2 zeigt ein Ablaufdiagramm eines Verfahrens zu einem Betrieb der Positioniervorrichtung und/oder des Be-und/oder Entladesystems 38a. In zumindest einem Verfahrensschritt 76a wird ein Wafer-Transportbehältnis 10a mittels des Wafer-Transportbehältnis-Transportsystems 50a an der Abzweigung des Schienensystems 56a, welche der Be- und/oder Entladestation 14a zugehörig ist, angeliefert. In zumindest einem weiteren Verfahrensschritt 78a wird eine Grobpositionierung des Wafer-Transportbehältnisses 10a relativ zu der Oberfläche 40a der Be- und/oder Entladestation 14a mittels des Grobpositioniermechanismus 60a vorgenommen. Dabei wird das durch die Halterung 58a mit dem Transportschlitten 54a verbundene Wafer-Transportbehältnis 10a an den Halteelementen 52a hängend vertikal entlang der Kopplungsrichtung 30a herabgelassen, bis es sich einem Nahbereich der Be- und/oder Entladestation 14a angenähert hat. In zumindest einem weiteren Verfahrensschritt 80a wird das Wafer-Transportbehältnis 10a im Anschluss an die externe Grobpositionierung positioniert, insbesondere vorpositioniert. Dabei wird bei dem Koppelvorgang zwischen dem Wafer-Transportbehältnis 10a und der Be- und/oder Entladestation 14a das Wafer-Transportbehältnis 10a von dem Positioniermechanismus 16a berührungslos relativ zu der Be- und/oder Entladestation 14a positioniert, insbesondere vorpositioniert. In zumindest einem weiteren Verfahrensschritt 82a wird das Wafer-Transportbehältnis 10a im Anschluss an die Positionierung, insbesondere die Vorpositionierung, mittels des Endpositioniermechanismus 36a endpositioniert. Dabei wird die Führungsschiene 46a des bereits vorpositionierten Wafer-Transportbehältnisses 10a in Eingriff mit dem Führungselement 44a der Be- und/oder Entladestation 14a gebracht. Falls nach der Positionierung durch den Positioniermechanismus 16a weiterhin kleine Abweichungen von einer idealen Be- und/oder Entladeposition vorhanden sind, werden diese durch den gegenseitigen Eingriff der Teile der Führungseinheit 42a ausgeglichen. In zumindest einem weiteren Verfahrensschritt 84a wird das Wafer-Transportbehältnis 10a geöffnet und die darin transportierten Wafer 12a werden über die Be- und/oder Entladestation 14a in das Wafer-Prozessmodul umgeladen. In zumindest einem weiteren Verfahrensschritt 86a werden Wafer 12a in das Wafer-Transportbehältnis 10a über die Be- und/oder Entladestation 14a eingeladen. Das an der Be- und/oder Entladestation 14a angedockte, geöffnete Wafer-Transportbehältnis 10a wird in dem Verfahrensschritt 86a wieder verschlossen. In zumindest einem weiteren Verfahrensschritt 88a wird das verschlossene Wafer-Transportbehältnis 10a durch das Wafer-Transportbehältnis-Transportsystem 50a angehoben und von der Be- und/oder Entladestation 14a entfernt. In zumindest einem weiteren Verfahrensschritt 90a wird das Wafer-Transportbehältnis 10a mittels des Wafer-Transportbehältnis-Transportsystems 50a von der der Be- und/oder Entladestation 14a zugehörigen Abzweigung des Schienensystems 56a abgefahren.

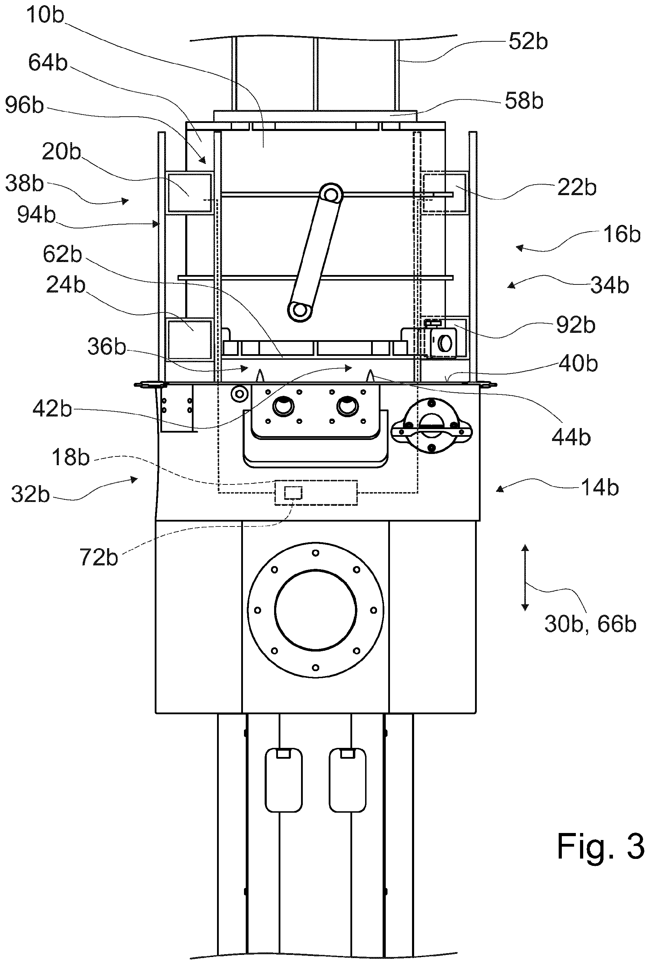

In den Figuren 3 bis 6 sind drei weitere Ausführungsbeispiele der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 und 2, verwiesen werden kann. Zur Unterscheidung der Ausführungsbeispiele ist der Buchstabe a den Bezugszeichen des Ausführungsbeispiels in den Figuren 1 und 2 nachgestellt. In den Ausführungsbeispielen der Figuren 3 bis 6 ist der Buchstabe a durch die Buchstaben b bis d ersetzt.

Fig. 3 zeigt eine schematische Darstellung eines Be- und/oder Entladesystems 38b mit einem Wafer-Transportbehältnis 10b, einer Be- und/oder Entladestation 14b und mit einer Positioniervorrichtung. In der in Fig. 3 gezeigten Darstellung befindet sich das Be- und/oder Entladesystem 38b in einem ungekoppelten Zustand. Das Wafer-Transportbehältnis 10b ist frei von einem Kontakt mit der Be- und/oder Entladestation 14b. Das Wafer-Transportbehältnis 10b befindet sich in einem Nahbereich der Be- und/oder Entladestation 14b. Die Positioniervorrichtung weist einen Positioniermechanismus 16b auf. Der Positioniermechanismus 16b umfasst Positionierelemente 20b, 22b, 24b, 92b. Die Positionierelemente 20b, 22b, 24b, 92b sind dazu vorgesehen, jeweils ein Positionierkraftfeld zu erzeugen. Die Positionierelemente 20b, 22b, 24b, 92b sind dazu vorgesehen, ein als ein Magnetfeld ausgebildetes Positionierkraftfeld zu erzeugen. Die Positionierkraftfelder sind dazu vorgesehen, mit dem Wafer-Transportbehältnis 10b wechselzuwirken. Das Wafer-Transportbehältnis 10b weist eine Außenhülle 96b auf. Die Außenhülle 96b ist zumindest teilweise aus einem Material ausgebildet, welches durch ein äußeres magnetisches Feld abgestoßen und/oder angezogen wird. Die Positionierkraftfelder sind dazu vorgesehen, mit einem Material der Außenhülle 96b des Wafer-Transportbehältnisses 10b wechselzuwirken. Alternativ oder zusätzlich können die Positionierelemente 20b, 22b, 24b, 92b dazu vorgesehen sein, ein als ein elektrisches Feld, insbesondere ein elektrostatisches Feld, ausgebildetes Positionierkraftfeld zu erzeugen.

Die Positioniervorrichtung weist eine Befestigungseinheit 94b auf. Die Befestigungseinheit 94b ist zu einer Lagerung der Positionierelemente 20b, 22b, 24b, 92b relativ zu der Be- und/oder Entladestation 14b vorgesehen. Die Befestigungseinheit umfasst zwei Doppelschienen, welche die Positionierelemente 20b, 22b, 24b, 92b unverlierbar mit der Be- und/oder Entladestation 14b verbinden. Die Positionierelemente 20b, 22b, 24b, 92b sind relativ zu einer Oberfläche 40b der Be- und/oder Entladestation 14b beweglich, insbesondere verschiebbar und schwenkbar, gelagert. Die Positionierelemente 20b, 22b, 24b, 92b sind dazu vorgesehen, bei einer Bewegung des Wafer-Transportbehältnisses 10b in Kopplungsrichtung 30b der Bewegung des Wafer-Transportbehältnisses 10b zumindest teilweise zu folgen. Dadurch kann vorteilhaft eine gute Stabilisierung einer durch die Positionierkraftfelder eingestellten Position bei einem Koppelvorgang zwischen Wafer-Transportbehältnis 10b und Be- und/oder Entladestation 14b erreicht werden. Die in Fig. 3 gezeigte Positioniervorrichtung weist vier Positionierelemente 20b, 22b, 24b, 92b auf, welche jeweils in Zweierpaaren an einer Doppelschiene montiert sind.

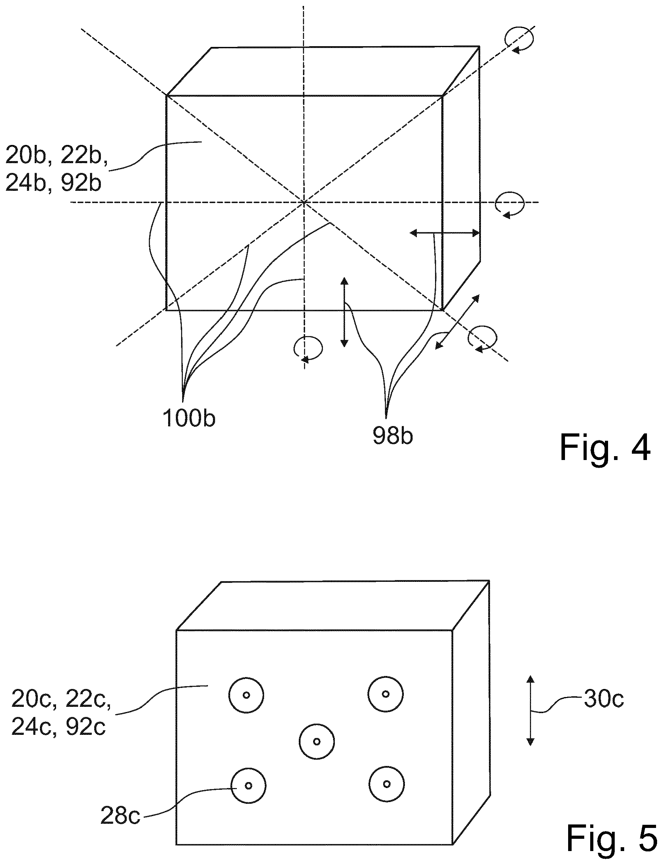

Alternativ kann die Positioniervorrichtung eine von vier verschiedene Anzahl von Positionierelementen 20b, 22b, 24b, 92b, eine von zwei verschiedene Anzahl von Positionierelementen 20b, 22b, 24b, 92b pro Doppelschiene und/oder eine von zwei verschiedene Anzahl von Doppelschienen aufweisen. Zudem können die Positionierelemente 20b, 22b, 24b, 92b auf andere Weise relativ zu der Oberfläche 40b der Be- und/oder Entladestation 14b beweglich und/oder schwenkbar gelagert sein, beispielsweise mittels eines dreidimensional schwenkbaren, sowie translatorisch verschiebbaren Dreh-, Kipp und/oder Schwenktischs und/oder mittels eines verschiebbar gelagerten Kugelgelenks (vgl. auch Fig. 4).

In Fig. 4 ist eine schematische Darstellung eines in viele Richtungen schwenk- und translatierbaren Positionierelements 20b, 22b, 24b, 92b gezeigt. Das gezeigte Positionierelement 20b, 22b, 24b, 92b ist beispielhaft entlang dreier Translationsachsen 98b in x-, y- und z-Richtung translatierbar. Das gezeigte Positionierelement 20b, 22b, 24b, 92b ist beispielhaft um vier Schwenkachsen 100b, welche horizontal, vertikal und in Winkeln von ±45° schräg zur Horizontalen ausgerichtet sind, schwenkbar. Alternativ sind weitere Schwenk- und/oder Translationsachsen denkbar. Vorteilhaft kann eine Präzision einer berührungslosen Positionierung erhöht werden je größer die Anzahl an möglichen, insbesondere ansteuerbaren, Schwenk- und/oder Translationspositionen des Positionierelements 20b, 22b, 24b, 92b ist.

In Fig. 5 ist eine schematische Darstellung eines weiteren alternativen Positionierelements 20c, 22c, 24c, 92c einer weiteren alternativen Positioniervorrichtung gezeigt. Das Positionierelement 20c, 22c, 24c, 92c ist dazu vorgesehen, ein als ein Strömungsfeld eines strömenden Gases ausgebildetes Positionierkraftfeld zu erzeugen. Das Positionierelement 20c, 22c, 24c, 92c weist eine Düse 28c auf. Die Düse 28c ist zu einer Erzeugung eines teilweise gerichteten Gasstroms vorgesehen. Aus der Düse 28c tritt bei einer aktiven Positionierung der teilweise gerichtete Gasstrom aus. Der Gasstrom der Düse 28c des Positionierelements 20c, 22c, 24c, 92c ist im Wesentlichen senkrecht zu einer Kopplungsrichtung 30c der Positioniervorrichtung ausgerichtet. Bei einem Austreten des teilweise gerichteten Gasstroms aus der Düse 28c befindet sich die Düse 28c in einem Blasbetrieb. In dem Blasbetrieb ist die Düse 28c dazu vorgesehen, ein Objekt, insbesondere Wafer-Transportbehältnis 10c von dem Positionierelement 20c, 22c, 24c, 92c wegzudrücken. Alternativ oder zusätzlich kann eine Düse 28c für einen Saugbetrieb vorgesehen sein. Bei einem Saugbetrieb ist der Gasstrom im Wesentlichen auf die Düse 28c gerichtet. Das Positionierelement 20c, 22c, 24c, 92c weist fünf separate Düsen 28c auf. Die Düsen 28c können zu einer Erzeugung des Gasstroms mit einem gemeinsamen Pumpensystem verbunden sein und/oder separate Pumpensysteme für zumindest zwei der Düsen 28c aufweisen. Alternativ kann das Positionierelement 20c, 22c, 24c, 92c eine von fünf verschiedene Anzahl von Düsen 28c aufweisen.

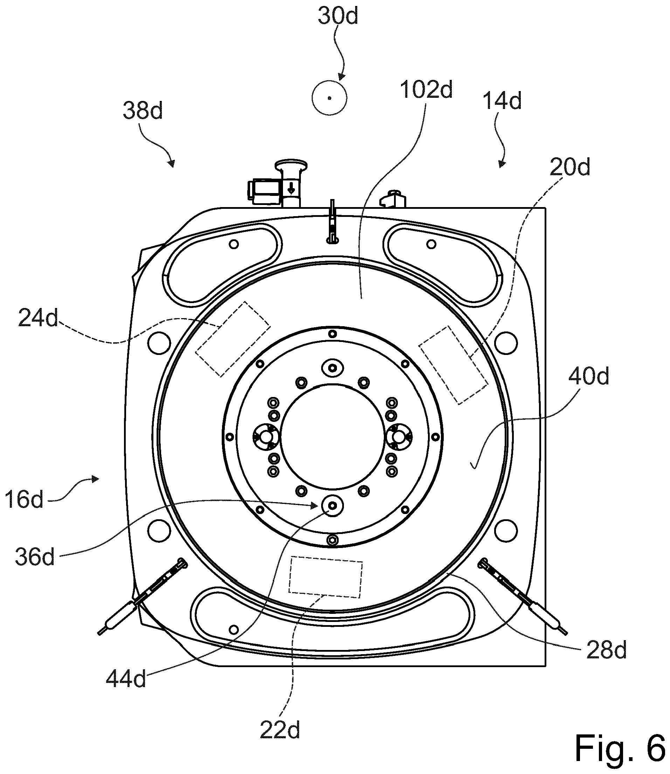

In Fig. 6 ist eine schematische Darstellung einer Draufsicht auf eine zusätzliche alternative Be- und/oder Entladestation 14d eines Be- und/oder Entladesystems 38d gezeigt. Das Be- und/oder Entladesystem 38d weist eine Positioniervorrichtung auf. Die Positioniervorrichtung weist einen Positioniermechanismus 16d auf. Der Positioniermechanismus 16d weist eine Düse 28d auf. Die Düse 28d ist zu einer Erzeugung eines teilweise gerichteten Gasstroms vorgesehen. Der Gasstrom ist im Wesentlichen parallel zu einer Kopplungsrichtung 30d der Positioniervorrichtung ausgerichtet. In der Fig. 6 liegt die Kopplungsrichtung 30d senkrecht zu der Zeichenebene. Die Düse 28d ist ringförmig ausgebildet. Die Düse 28d bildet eine geschlossene Ringform aus. Alternativ kann die Düse 28d eine von einer Ringform abweichende geschlossene Form oder eine teilweise unterbrochene Form, welche ringförmig und/oder von einer Ringform abweichend ausgebildet sein kann, aufweisen. Die Düse 28d ist ringförmig um einen Bereich der Be- und/oder Entladestation 14d angeordnet, welcher dazu vorgesehen ist, ein Wafer-Transportbehältnis 10d aufzunehmen. Die Düse 28d ist ringförmig um einen Bereich der Be- und/oder Entladestation 14d angeordnet, welcher dazu vorgesehen ist, zu einer Öffnung des Wafer-Transportbehältnisses 10d in ein Inneres der Be- und/oder Entladestation 14d abgesenkt zu werden. Die Düse 28d ist ringförmig um ein Öffnungselement 102d der Be- und/oder Entladestation 14d angeordnet. Die Düse 28d ist dazu vorgesehen, in einem aktiven Betrieb einen Luftvorhang rings um das Öffnungselement 102d der Be- und/oder Entladestation 14d auszubilden. Die Düse 28d ist dazu vorgesehen, in einem aktiven Betrieb einen Luftvorhang rings um den Bereich der Be- und/oder Entladestation 14d, welcher dazu vorgesehen ist, das Wafer-Transportbehältnis 10d aufzunehmen, auszubilden. Die Düse 28d ist dazu vorgesehen, in einem aktiven Betrieb einen Luftvorhang rings um den Bereich der Be- und/oder Entladestation 14d, welcher zu der Öffnung des Wafer-Transportbehältnisses 10d in das Innere der Be- und/oder Entladestation 14d abgesenkt wird, auszubilden.

### Bezugszeichen

- 10: Wafer-Transportbehältnis
- 12: Wafer
- 14: Be- und/oder Entladestation
- 16: Positioniermechanismus
- 18: Steuer- und/oder Regeleinheit
- 20: Positionierelement
- 22: Positionierelement
- 24: Positionierelement
- 26: Permanentmagnet
- 28: Düse
- 30: Kopplungsrichtung
- 32: Kontrolleinheit
- 34: Sensoreinheit
- 36: Endpositioniermechanismus
- 38: Be- und/oder Entladesystem
- 40: Oberfläche
- 42: Führungseinheit
- 44: Führungselement
- 46: Führungsschiene
- 48: Sensorelement
- 50: Wafer-Transportbehältnis-Transportsystem
- 52: Halteelement
- 54: Transportschlitten
- 56: Schienensystem
- 58: Halterung
- 60: Grobpositioniermechanismus
- 62: Wafer-Transportbehältnis-Öffnungselement
- 64: Grundkörper
- 66: Be- und/oder Entladerichtung
- 68: Steuereinheit
- 70: Grundkörper
- 72: Kommunikationsmodul
- 74: Kommunikationsmodul
- 76: Verfahrensschritt
- 78: Verfahrensschritt
- 80: Verfahrensschritt
- 82: Verfahrensschritt
- 84: Verfahrensschritt
- 86: Verfahrensschritt
- 88: Verfahrensschritt
- 90: Verfahrensschritt
- 92: Positionierelement
- 94: Befestigungseinheit
- 96: Außenhülle
- 98: Translationsachse
- 100: Schwenkachse
- 102: Öffnungselement

## Patentansprüche

1. Positioniervorrichtung, insbesondere Wafer-Transportbehältnis-Positioniervorrichtung, zu einer Positionierung eines Wafer-Transportbehältnisses (10a-d) in einer Be- und/oder Entladeposition einer zumindest zum Be- und/oder Entladen von Wafern (12a-d) aus dem Wafer-Transportbehältnis (10a-d) vorgesehenen Be- und/oder Entladestation (14a-d), **gekennzeichnet durch** einen Positioniermechanismus (16a-d), welcher zu einer berührungslosen Positionierung des Wafer-Transportbehältnisses (10a-d) bei einem Koppelvorgang des Wafer-Transportbehältnisses (10a-d) mit der Be- und/oder Entladestation (14a-d) vorgesehen ist.

2. Positioniervorrichtung nach Anspruch 1, **dadurch gekennzeichnet, dass** der Positioniermechanismus (16a-d) zu einer Nahbereichspositionierung des Wafer-Transportbehältnisses (10a-d) in der Be- und/oder Entladeposition vorgesehen ist.

3. Positioniervorrichtung nach Anspruch 1 oder 2, **dadurch gekennzeichnet, dass** der Positioniermechanismus (16a-d) dazu vorgesehen ist, das Wafer-Transportbehältnis (10a-d) so zu positionieren, dass eine Abweichung von einer idealen Be- und/oder Entladeposition höchstens 3 mm beträgt.

4. Positioniervorrichtung nach einem der vorhergehenden Ansprüche, **gekennzeichnet durch** eine Steuer- und/oder Regeleinheit (18a-d), welche dazu vorgesehen ist, die Positionierung des Wafer-Transportbehältnisses (10a-d) mittels des Positioniermechanismus (16a-d) zu steuern und/oder zu regeln.

5. Positioniervorrichtung nach einem der vorhergehenden Ansprüche, **dadurch gekennzeichnet, dass** der Positioniermechanismus (16a-d) zumindest ein Positionierelement (20a-d, 20'a-d, 22a-d, 22'a-d, 24a-d, 24'a-d, 92b-d) umfasst, welches dazu vorgesehen ist, zumindest ein Positionierkraftfeld zu erzeugen.

6. Positioniervorrichtung nach Anspruch 5, **dadurch gekennzeichnet, dass** der Positioniermechanismus (16a-d) zumindest ein weiteres Positionierelement (20a-d, 20'a-d, 22a-d, 22'a-d, 24a-d, 24'a-d, 92b-d) umfasst, welches dazu vorgesehen ist, zumindest ein weiteres Positionierkraftfeld zu erzeugen.

7. Positioniervorrichtung nach einem der vorhergehenden Ansprüche, **dadurch gekennzeichnet, dass** der Positioniermechanismus (16a-d) dazu vorgesehen ist, zu der Positionierung zumindest eine abstoßende Kraft zu erzeugen.

8. Positioniervorrichtung zumindest nach Anspruch 5, **dadurch gekennzeichnet, dass** zumindest ein Positionierelement (20a-d, 20'a-d, 22a-d, 22'a-d, 24a-d, 24'a-d, 92b-d) zumindest dazu vorgesehen ist, zumindest ein als ein Magnetfeld ausgebildetes Positionierkraftfeld zu erzeugen.

9. Positioniervorrichtung zumindest nach Anspruch 5, **dadurch gekennzeichnet, dass** zumindest ein Positionierelement (20a-d, 20'a-d, 22a-d, 22'a-d, 24a-d, 24'a-d, 92b-d) zumindest teilweise als ein Permanentmagnet (26a-d) ausgebildet ist.

10. Positioniervorrichtung zumindest nach Anspruch 5, **dadurch gekennzeichnet, dass** zumindest ein Positionierelement (20'a, 22'a, 24'a) zumindest teilweise einstückig mit dem Wafer-Transportbehältnis (10a-d) ausgebildet ist.

11. Positioniervorrichtung zumindest nach Anspruch 5, **dadurch gekennzeichnet, dass** zumindest ein Positionierelement (20a-d, 20'a-d, 22a-d, 22'a-d, 24a-d, 24'a-d, 92b-d) unverlierbar mit der Be- und/oder Entladestation (14a-d) verbunden ist.

12. Positioniervorrichtung nach Anspruch 11, **dadurch gekennzeichnet, dass** das Positionierelement (20b-c, 20'b-c, 22b-c, 22'b-c, 24b-c, 24'b-c, 92b) relativ zu der Be- und/oder Entladestation (14b-c) beweglich gelagert ist.

13. Positioniervorrichtung zumindest nach Anspruch 5, **dadurch gekennzeichnet, dass** zumindest ein Positionierelement (20c-d, 22c-d, 24c-d, 92c-d) dazu vorgesehen ist, zumindest ein als ein Strömungsfeld eines strömenden Gases ausgebildetes Positionierkraftfeld zu erzeugen.

14. Positioniervorrichtung nach einem der vorhergehenden Ansprüche, **dadurch gekennzeichnet, dass** der Positioniermechanismus (16d) zumindest eine Düse (28d) zu einer Erzeugung eines zumindest teilweise gerichteten Gasstroms aufweist, wobei der Gasstrom zumindest im Wesentlichen parallel zu einer Kopplungsrichtung (30d) der Positioniervorrichtung ausgerichtet ist.

15. Positioniervorrichtung nach Anspruch 13 oder 14, **dadurch gekennzeichnet, dass** zumindest ein Gasstrom des Positionierelements (20c-d, 22c-d, 24c-d) zumindest im Wesentlichen senkrecht zu einer Kopplungsrichtung (30c-d) der Positioniervorrichtung ausgerichtet ist.

16. Positioniervorrichtung nach einem der vorhergehenden Ansprüche, **gekennzeichnet durch** eine Kontrolleinheit (32a-d) zu einer Positionskontrolle und/oder zu einer Positionsregelung einer Ist-Position des Wafer-Transportbehältnisses (10a-d) während des Koppelvorgangs.

17. Positioniervorrichtung nach Anspruch 16, **dadurch gekennzeichnet, dass** die Kontrolleinheit (32a-d) zumindest eine Sensoreinheit (34a-d) aufweist, wobei die Sensoreinheit (34a-d) zumindest teilweise einstückig mit dem Positioniermechanismus (16a-d) ausgebildet ist.

18. Positioniervorrichtung nach einem der vorhergehenden Ansprüche, **gekennzeichnet durch** einen Endpositioniermechanismus (36a-d), wobei der Positioniermechanismus (16a-d) zumindest teilweise getrennt von dem Endpositioniermechanismus (36a-d) ausgebildet ist.

19. Be- und/oder Entladesystem (38a-d) zu einem Be- und/oder Entladen von Wafern (12a-d) aus einem Wafer-Transportbehältnis (10a-d), mit dem Wafer-Transportbehältnis (10a-d), mit einer Be- und/oder Entladestation (14a-d) und mit einer Positioniervorrichtung nach einem der vorhergehenden Ansprüche.

20. Verfahren zum Betrieb einer Positioniervorrichtung, insbesondere nach einem der Ansprüche 1 bis 18, und/oder eines Be- und/oder Entladesystems (38a-d) nach Anspruch 19, **dadurch gekennzeichnet, dass** bei einem Koppelvorgang zwischen einem Wafer-Transportbehältnis (10a-d) und einer Be- und/oder Entladestation (14a-d) das Wafer-Transportbehältnis (10a-d) berührungslos relativ zu der Be- und/oder Entladestation (14a-d) positioniert wird.

21. Verfahren nach Anspruch 20, **dadurch gekennzeichnet, dass** das Wafer-Transportbehältnis (10a-d) im Anschluss an eine externe Grobpositionierung positioniert wird.
